# EUROPEAN PATENT APPLICATION

(11) **EP 4 468 830 A1**
(43) Date of publication of application: **27.11.2024**
(21) Application number: 24177180.7
(22) Date of filing: 21.05.2024
(51) Int. Cl.: H05K 1/02, H05K 1/09, H05K 1/16

(54) **CONDUCTIVE STRUCTURES AND HOUSING STRUCTURES FOR TRANSMISSION ON DEFORMABLE SURFACES**

(30) Priority: 21.05.2023 US 202363467998 P; 01.07.2023 US 202363524644 P; 29.12.2023 US 202363616280 P; 30.12.2023 US 202363616514 P; 28.03.2024 US 202463571338 P
(71) Applicant: Van de Zande, Charles Tyson, Cary, North Carolina 27518 (US)
(72) Inventor: Van de Zande, Charles Tyson, Cary, North Carolina 27518 (US)
(74) Representative: Boult Wade Tennant LLP

(57) **Abstract**

A stacked structure can include a first deposited flexible dielectric layer, a flexible electrical conductor on the first deposited flexible dielectric layer and configured to conduct an electrical signal, and a second deposited flexible dielectric layer on the flexible electrical conductor opposite the first deposited flexible dielectric layer. A housing structure can be coupled to the stacked structure, where the housing structure can include a side wall extending around a perimeter to define an interior region of the housing structure forming a recess that is configured to hold a packaged integrated circuit device and to define an exterior region of the housing structure that is outside the side wall and a flange coupled to a portion of the side wall to cantilever over the exterior region of the housing structure. Other embodiments and aspects of the invention are also disclosed herein.

## Description

### CROSS-REFERENCE TO RELATED APPLICATIONS

This application claims priority to the following U.S. Provisional Patent Applications filed in the U.S.P.T.O: Serial No. 63/467,998 (Attorney Docket No. 4015-0005PR) titled Structure of Dielectrics & Traces to Hold Stable Voltage Potential on Textile Circuitry, filed May 21, 2023, to Serial No. 63/524,644 (Attorney Docket No. 4015-0007PR) titled Structure of Dielectrics & Traces to Hold Stable Voltage Potential on Textile Circuitry + Communicate Data through Frequency Modulated Signals, filed July 1, 2023, to Serial No. 63/616,280 (Attorney Docket No. 4015-0008PR) titled Integrated Circuit Package for Flexible Circuit Boards, Including Fabric, filed December 29 2023, to Serial No. 63/616,514 (Attorney Docket No. 4015-0009PR) titled Integrated Circuit Package for Flexible Circuit Boards, Including Fabric, filed December 30, 2023, and to Serial No. 63/571,338 filed March 28, 2024, the entire disclosure of each of which is incorporated herein by reference.

### FIELD

The invention relates to the field of electronics in general, and more particularly, to electronic circuits.

### BACKGROUND

Smartphones and personal computers have become important parts of various applications, offering a plethora of functionalities. Despite their versatility, their inherent limitations can stem from the compact form factor of self-contained devices and rigidity. These devices typically include displays, cameras, batteries, charging units, memories, central processing units, wireless communication interfaces, touch sensors, and enclosures. The convergence of these components within the confines of a single device aims to maximize functionality while maintaining a compact, handheld design.

The decentralization of these components can occur for specific purposes such as heat dissipation or integration into and/or interaction with a physical environment. These environments can range from tabletop installations to integrated systems within buildings, like server farms with centralized interactive points. Traditionally, these components have been connected using materials like copper, steel, or alloys, coated with polymeric dielectrics, with data transfer facilitated by fiber optics. Wireless communication protocols may also enable redundancy in components like batteries or CPUs. Moreover, devices such as smartphones, tablets, and laptops, may be connected using ribbon cables or printed circuit board traces, optimizing space while ensuring seamless functionality.

### SUMMARY

Embodiments according to the present invention can provide conductive structures and housing structures for data transmission on flexible substrates. Embodiments of the present invention can provide stacked structures, as for example transmission paths, to mitigate the effects on the signal integrity, such as unintended voltage fluctuations, due to those deformations, unintended voltage fluctuations originating from the environment such as Wi-Fi signals, cell tower signals, radar signals, light signals, and movement/manipulation of a substrate on which the stacked structures may be formed.

In some embodiments according to the invention, a stacked structure can include a first deposited flexible dielectric layer, a flexible electrical conductor on the first deposited flexible dielectric layer and configured to conduct an electrical signal, and a second deposited flexible dielectric layer on the flexible electrical conductor opposite the first deposited flexible dielectric layer.

In some embodiments according to the invention, a housing structure can be coupled to the stacked structure, where the housing structure can include a side wall extending around a perimeter to define an interior region of the housing structure forming a recess that is configured to hold a packaged integrated circuit device and to define an exterior region of the housing structure that is outside the side wall and a flange coupled to a portion of the side wall to cantilever over the exterior region of the housing structure. Other embodiments and aspects of the invention are also disclosed herein.

Certain illustrative examples are described in the following numbered clauses:
Clause 1. A stacked structure comprising:
   a first deposited flexible dielectric layer;
   a flexible electrical conductor on the first deposited flexible dielectric layer and configured to conduct an electrical signal; and
   a second deposited flexible dielectric layer on the flexible electrical conductor opposite the first deposited flexible dielectric layer.
Clause 2. The stacked structure of Clause 1 wherein the flexible electrical conductor comprises a deposited flexible electrically conductive layer; and
   wherein each of the first deposited flexible dielectric layer, the deposited flexible electrically conductive layer, and the second deposited flexible dielectric layer has a respective thickness in a first direction to provide a thickness of the stacked structure.
Clause 3. The stacked structure of Clauses 1 or 2 wherein the first and second deposited flexible dielectric layers comprise different layers.
Clause 4. The stacked structure of Clauses 2 or 3 wherein the first and second deposited flexible dielectric layers comprises polymer ink, elastomeric urethane, elastomeric silicone, plasticized acrylic, and/or solvent-disperse polymer and wherein the deposited flexible electrically conductive layer comprises conductive ink, silver nanoparticle, and/or copper nanoparticle ink.
Clause 5. The stacked structure of any one of Clauses 2 to 4 wherein each of the first deposited flexible dielectric layer, the deposited flexible electrically conductive layer, and the second deposited flexible dielectric layer has a respective width in a second direction, that is different that the first direction.
Clause 6. The stacked structure of any one of Clauses 2 to 5 wherein the first and second deposited flexible dielectric layers are about a first width and the deposited flexible electrically conductive layer has a second width that is less than the first width.
Clause 7. The stacked structure of Clauses 5 or 6 wherein each of the first deposited flexible dielectric layer, the deposited flexible electrically conductive layer, and the second deposited flexible dielectric layer has a respective length in a third direction, that is different that the first and second directions.
Clause 8. The stacked structure of any one of Clauses 5 to 7 wherein the first and second deposited flexible dielectric layers are combined to surround the deposited flexible electrically conductive layer in the first and second directions, the stacked structure further comprising:
   a deposited flexible conductive shield layer surrounding the first and second deposited flexible dielectric layers and the deposited flexible electrically conductive layer in the first and second directions.
Clause 9. The stacked structure of Clause 8 wherein the first and second deposited flexible dielectric layers have a combined width that is greater than a width of the deposited flexible conductive shield layer.
Clause 10. The stacked structure of any one of Clauses 5 to 7 further comprising:
   a first deposited flexible conductive shield layer between a flexible substrate and the first deposited flexible dielectric layers; and
   a second deposited flexible conductive shield layer on the deposited flexible electrically conductive layer in the first and second directions and partially surrounding the first and second deposited flexible dielectric layers.
Clause 11. The stacked structure of any one of Clauses 2 to 10 further comprising:
   a third deposited flexible dielectric layer between the first and second deposited flexible dielectric layers directly adjacent to the deposited flexible electrically conductive layer, wherein the third deposited flexible dielectric layer has a third dielectric constant;
   a fourth deposited flexible dielectric layer between the first and second deposited flexible dielectric layers directly adjacent to the deposited flexible electrically conductive layer opposite the third deposited flexible dielectric layer, wherein the fourth deposited flexible dielectric layer has a fourth dielectric constant that is difference than the third dielectric constant.
Clause 12. The stacked structure of any one of Clauses 1 to 10 wherein the first deposited flexible dielectric layer has a first dielectric constant and the second deposited flexible dielectric layer has a second dielectric constant, the stacked structure further comprising:
   a third deposited flexible dielectric layer on the second deposited flexible dielectric layer, wherein the third deposited flexible dielectric layer has a third dielectric constant;
   a fourth deposited flexible dielectric layer on the first deposited flexible dielectric layer opposite the third deposited flexible dielectric layer, wherein the fourth deposited flexible dielectric layer has a fourth dielectric constant that is different than the first and third dielectric constants.
Clause 13. The stacked structure of any one of Clauses 2 to 12 wherein the deposited flexible electrically conductive layer comprises a first deposited flexible electrically conductive layer, the stacked structure further comprising:
   a second deposited flexible electrically conductive layer between the first and second deposited flexible dielectric layers directly adjacent to the first deposited flexible electrically conductive layer; and
   a third deposited flexible electrically conductive layer between the first and second deposited flexible dielectric layers directly adjacent to the first deposited flexible electrically conductive layer opposite the second deposited flexible electrically conductive layer.
Clause 14. The stacked structure of Clause 13 further comprising:
   a fourth deposited flexible electrically conductive layer between the first and second deposited flexible dielectric layers directly adjacent to the second deposited flexible electrically conductive layer opposite the first deposited flexible electrically conductive layer, wherein the first and fourth deposited flexible electrically conductive layers both comprise electrical ground layers and wherein the second and third deposited flexible electrically conductive layers both comprise electrical signal layers.
Clause 15. The stacked structure of any one of Clauses 2 to 14 wherein the deposited flexible electrically conductive layer is directly on the first deposited flexible dielectric layer and the second deposited flexible dielectric layer is directly on the deposited flexible electrically conductive layer.
Clause 16. The stacked structure of any one of Clauses 2 to 15 wherein each of the deposited flexible electrically conductive layer, the first deposited flexible dielectric layer, and the second deposited flexible dielectric layer exhibits a respective electrically functional bending radius in a range between about 2 mm and about 0.5 mm.
Clause 17. The stacked structure of any one of Clauses 2 to 16 wherein the deposited flexible electrically conductive layer comprises a crease-able electrically conductive layer, the first deposited flexible dielectric layer comprises a first crease-able dielectric layer, and the second deposited flexible dielectric layer comprises a second crease-able dielectric layer; and
   wherein each of the crease-able electrically conductive layer, the first crease-able dielectric layer, and the second crease-able dielectric layer exhibits a respective functional natural bending angle in a range between about 1 degrees and about 180 degrees.
Clause 18. The stacked structure of any one of Clauses 2 to 17 wherein the first deposited flexible dielectric layer, the second deposited flexible dielectric layer, and the deposited flexible electrically conductive layer each comprise a respective upper planar surface and a respective lower planar surface.
Clause 19. The stacked structure of any one of Clauses 1 to 18 wherein the first deposited flexible dielectric layer has a first thickness in a range between about 0.01 mm and about 3.0 mm.
Clause 20. The stacked structure of any one of Clauses 1 to 19 wherein the first deposited flexible dielectric layer has a first thickness in a range between about 0.05 mm and about 2.5 mm.
Clause 21. The stacked structure of any one of Clauses 1 to 20 wherein the first deposited flexible dielectric layer has a first thickness in a range between about 0.1 mm and about 2.0 mm.
Clause 22. The stacked structure of any one of Clauses 2 to 21 wherein the first deposited flexible dielectric layer has a first thickness that is greater than a second thickness of the second deposited flexible dielectric layer wherein a difference between the first thickness and the second thickness is configured to bend the stacked structure in a third direction by a specified amount along a length of the stacked structure.
Clause 23. The stacked structure of any one of Clauses 2 to 22 wherein the deposited flexible conductive layer comprises a first deposited flexible conductive layer, the stacked structure further comprising:
   a second deposited flexible conductive layer between the first deposited flexible conductive layer and the second deposited flexible dielectric layer to provide an upper capacitor plate;
   a third deposited flexible conductive layer between the first deposited flexible conductive layer and the first deposited flexible dielectric layer to provide a lower capacitor plate; and
   a third deposited flexible dielectric layer between the upper capacitor plate and the lower capacitor plate.
Clause 24. The stacked structure of Clause 23 further comprising:
   a first deposited flexible conductive shield layer on the first deposited flexible dielectric layer; and
   a second deposited flexible conductive shield layer on the second deposited flexible dielectric layer.
Clause 25. The stacked structure of any one of Clauses 1 to 8 or Clauses 11 to 22 further comprising:
   a first deposited flexible conductive shield layer on the first deposited flexible dielectric layer; and
   a second deposited flexible conductive shield layer on the second deposited flexible dielectric layer.
Clause 26. The stacked structure of Clause 25 wherein the flexible electrical conductor comprises a deposited flexible electrically conductive layer; and
   wherein each of the first deposited flexible dielectric layer, the deposited flexible electrically conductive layer, the second deposited flexible dielectric layer, the first deposited flexible conductive shield layer, and the second deposited flexible conductive shield layer has a respective thickness in a first direction to provide a thickness of the stacked structure.
Clause 27. The stacked structure of Clause 26 wherein each of the first deposited flexible dielectric layer, the deposited flexible electrically conductive layer, the second deposited flexible dielectric layer, the first deposited flexible conductive shield layer, and the second deposited flexible conductive shield layer has a respective width in a second direction, that is different that the first direction.
Clause 28. The stacked structure of Clause 27 wherein each of the first deposited flexible dielectric layer, the deposited flexible electrically conductive layer, the second deposited flexible dielectric layer, the first deposited flexible conductive shield layer, and the second deposited flexible conductive shield layer has a respective length in a third direction, that is different that the first and second directions.
Clause 29. The stacked structure of any one of Clauses 2 to 28 wherein the flexible electrical conductor comprises a plurality of deposited flexible electrically conductive layers spaced apart from one another between the first and second deposited flexible dielectric layers; and
   wherein each of the plurality of deposited flexible electrically conductive layers is configured to conduct separate electrical signals.
Clause 30. The stacked structure of any one of Clauses 7 to 29 wherein the flexible electrical conductor comprises a conductive thread integrated into a fabric in the third direction, the fabric having a first surface and a second surface that is opposite the first surface;
   wherein the first deposited flexible dielectric layer is attached to the first surface of the fabric; and
   wherein the second deposited flexible dielectric layer is attached to the second surface of the fabric.
Clause 31. The stacked structure of Clause 30 wherein the conductive thread is integrated into the fabric to alternatingly cross over opposite sides of directly adjacent ones of a plurality of first dielectric threads extending in the second direction.
Clause 32. The stacked structure of Clause 30 or 31 further comprising:
   a first deposited flexible conductive shield layer on the first deposited flexible dielectric layer; and
   a second deposited flexible conductive shield layer on the second deposited flexible dielectric layer.
Clause 33. The stacked structure of any one of Clauses 30 to 32 wherein the conductive thread comprises a first conductive thread, wherein the stacked structure further comprising:
   a plurality of second dielectric threads spaced apart in the first direction; and
   a second conductive thread spaced apart from the first conductive thread in the second direction and integrated into the fabric in the first direction to alternatingly cross over opposite sides of directly adjacent ones of the plurality of second dielectric threads.
Clause 34. The stacked structure of Clauses 32 or 33 further comprising:
   a third deposited flexible dielectric layer on the first deposited flexible conductive shield layer; and
   a fourth deposited flexible dielectric layer on the second deposited flexible conductive shield layer.
Clause 35. The stacked structure of any one of Clauses 1 to 34 wherein the stacked structure extends at a first level to form a second level that overlaps the first level.
Clause 36. The stacked structure of any one of Clauses 2 to 35, wherein the deposited flexible dielectric layer includes a first surface and a second surface that is opposite the first surface;
   wherein the deposited flexible electrically conductive layer comprises a first deposited flexible electrically conductive layer defining a first serpentine pattern on the deposited flexible dielectric layer including a plurality of first segments on the first surface of the deposited flexible dielectric layer and including a plurality of second segments on the second surface of the deposited flexible dielectric layer, the stacked structure further comprising:
   a second deposited flexible electrically conductive layer defining a second serpentine pattern on the deposited flexible dielectric layer interlaced with the first serpentine pattern, the second deposited flexible electrically conductive layer including a plurality of first segments on the first surface of the deposited flexible dielectric layer and including a plurality of second segments on the second surface of the deposited flexible dielectric layer;
   a plurality of first vias passing through the deposited flexible dielectric layer to connect the first and second segments of first serpentine pattern together; and
   a plurality of second vias passing through the deposited flexible dielectric layer to connect the first and second segments of second serpentine pattern together.
Clause 37. The stacked structure of Clause 36 further comprising:
   a pattern including a dielectric material and a piezoelectric material, the pattern located on the deposited flexible dielectric layer opposite where segments of the first and second serpentine patterns cross one another.
Clause 38. The stacked structure of any one of Clauses 1 to 37 further comprising:
   a garment including portions tailored for respective body parts;
   a plurality electrical signal interconnects extending among the portions tailored for the respective body parts on the garment, the plurality of the electrical signal interconnects configured to conduct electrical signals among devices that are coupled to the garment;
   wherein the first deposited flexible dielectric layer comprises a first crease-able dielectric layer coupled to the garment;
   wherein the flexible electrical conductor comprises a crease-able electrically conductive layer on the first crease-able dielectric layer and configured to electrically conduct the electrical signals;
   wherein the second deposited flexible dielectric layer comprises a second crease-able dielectric layer on the crease-able electrically conductive layer opposite the first crease-able dielectric layer; and
   a plurality of electrical devices coupled to the garment and coupled to respective ones of the plurality electrical signal interconnects.
Clause 39. A garment comprising the stacked structure according to any one of Clauses 1 to 38.
Clause 40. A garment comprising:
   a wearable textile
   a plurality electrical signal interconnects extending among the portions tailored for the respective body parts on the wearable fabric, the plurality of the electrical signal interconnects configured to conduct electrical signals among devices that are coupled to the wearable fabric, each of the electrical signal interconnects including:
      a first crease-able dielectric layer coupled to the wearable fabric;
      a crease-able electrically conductive layer on the first crease-able dielectric layer and configured to electrically conduct an electrical signal;
      a second crease-able dielectric layer on the crease-able electrically conductive layer opposite the first crease-able dielectric layer; and
      a plurality of electrical devices coupled to the wearable fabric and coupled to respective ones of the plurality electrical signal interconnects.
Clause 41. A stacked structure comprising:
   a flexible dielectric layer having a first surface and a second surface opposite the first surface;
   a first flexible electrically conductive layer defining a first serpentine pattern on the flexible dielectric layer including a plurality of first segments on the first surface of the flexible dielectric layer and including a plurality of second segments on the second surface of the flexible dielectric layer;
   a second flexible electrically conductive layer defining a second serpentine pattern on the flexible dielectric layer interlaced with the first serpentine pattern, the second flexible electrically conductive layer including a plurality of first segments of on the first surface of the flexible dielectric layer and including a plurality of second segments on the second surface of the flexible dielectric layer;
   a plurality of first vias passing through the flexible dielectric layer to connect the first and second segments of first serpentine pattern together; and
   a plurality of second vias passing through the flexible dielectric layer to connect the first and second segments of second serpentine pattern together.
Clause 42. The stacked structure of Clause 41 further comprising:
   a pattern including a dielectric material and a piezoelectric material, the pattern located on the flexible dielectric layer opposite where segments of the first and second serpentine patterns cross one another.
Clause 43. A housing structure comprising:
   a side wall extending around a perimeter to define an interior region of the housing structure forming a recess that is configured to hold a packaged integrated circuit device and to define an exterior region of the housing structure that is outside the side wall; and
   a flange coupled to a portion of the side wall to cantilever over the exterior region of the housing structure.
Clause 44. The housing structure of Clause 43 further comprising:
   a plurality of pads spaced apart along the perimeter on the side wall in the exterior region of the housing structure.
Clause 45. The housing structure of Clause 44 wherein each of the plurality of pads further comprises:
   a base portion configured to electrically couple to an electrical conductor beneath the flange;
   a side wall portion that extends through a portion of the side wall proximate a hinge portion of the flange; and
   a tapered portion that electrically couples the base portion to the side wall portion.
Clause 46. The housing structure of any one of Clauses 43 to 45 further comprising:
   a deposited circuit substrate adjacent to the hinge portion of the flange extending into the interior region.
Clause 47. The housing structure of any one of Clauses 44 to 46 wherein the plurality of pads comprises a conductive material having a first melting point.
Clause 48. The housing structure of Clause 47 wherein the conductive material comprises a plastic and a conductive component.
Clause 49. The housing structure of any one of Clauses 43 to 48 wherein the housing structure is configured to removably hold the packaged integrated circuit device.
Clause 50. The housing structure of any one of Clauses 44 to 49 wherein the plurality of pads comprises a conductive adhesive having a first melting point.
Clause 51. The housing structure of any one of Clauses 44 to 50 wherein the plurality of pads extend through the side wall.
Clause 52. The housing structure of Clause 50 or 51 wherein the conductive adhesive extends through the side wall.
Clause 53. The housing structure of any one of Clauses 50 to 52 wherein the flange comprises a material having a second melting point that is greater than the first melting point.
Clause 54. The housing structure of any one of Clauses 43 to 53 wherein the flange further comprises:
   a plurality of openings through the flange spaced apart along the perimeter.
Clause 55. The housing structure of Clause 54 wherein each of the plurality of openings has a diameter in a range between about 0.01 mm to about 0.50 mm.
Clause 56. The housing structure of any one of Clauses 43 to 55 wherein the flange includes:
   a living hinge coupling an upper edge of the flange to the portion of the side wall, wherein the living hinge biases the flange to slope downward away from the side wall.
Clause 57. The housing structure of any one of Clauses 43 to 56 further comprising:
   an opening in the recess configured to receive the packaged integrated circuit device for insertion into the recess.
Clause 58. The housing structure of Clause 57 wherein the opening is at an edge of the side wall that is remote from a hinge portion of the flange.
Clause 59. The housing structure of any one of Clauses 43 to 58 further comprising:
   a lip at the edge of the side wall, wherein the lip protrudes into the interior region around the perimeter by an amount configured to secure the packaged integrated circuit device in the recess.
Clause 60. The housing structure of any one of Clauses 57 to 59 further comprising:
   a lid coupled to the edge of the side wall around the perimeter to close the recess opposite the opening.
Clause 61. The housing structure of any one of Clauses 57 to 60 wherein the opening is at an edge of the side wall that is proximate to a hinge portion of the flange.
Clause 62. The housing structure of any one of Clauses 44 to 61 wherein the plurality of pads spaced apart along the perimeter at an edge of the side wall that is remote from a hinge portion of the flange in the exterior region of the housing structure.
Clause 63. The housing structure of any one of Clauses 44 to 62 wherein the plurality of pads spaced apart along the perimeter at an edge of the side wall that is remote from a hinge portion of the flange in the exterior region of the housing structure.
Clause 64. The housing structure of any one of Clauses 43 to 63 further comprising:
   a tail of the flange remote from the side wall in the exterior region; and
   a plurality of openings through the tail in the exterior region spaced apart to follow the perimeter.
Clause 65. The housing structure of any one of Clauses 43 to 64 further comprising:
   a tail of the flange remote from the side wall in the exterior region; and
   a plurality of rivets through the tail in the exterior region spaced apart to follow the perimeter.
Clause 66. The housing structure of any one of Clauses 43 to 65 further comprising:
   a plurality of leads spaced apart along the perimeter on the side wall in the exterior region of the housing structure, wherein each of the plurality of leads includes:
   an upper portion extending through the side wall and sloped downward away from the side wall in the exterior region;
   a lower portion extending away from the side wall in the exterior region and configured to electrically couple to a deposited flexible electrical conductor; and
   an intermediate portion electrically coupling the lower portion to the upper portion.
Clause 67. The housing structure of any one of Clauses 43 to 66 wherein the housing structure comprises an integrated circuit package wherein:
   the side wall extends around a perimeter to define the interior region of the integrated circuit package to form the recess configured to hold an integrated circuit die and to define the exterior region of the integrated circuit package outside the side wall; and
   the flange is coupled to an upper portion of the side wall to cantilever over the exterior region of the integrated circuit package.
Clause 68. The housing structure of Clause 67 wherein the flange includes:
   a living hinge coupling an upper edge of the flange to the upper portion of the side wall, wherein the living hinge biases the flange to slope downward away from the side wall.
Clause 69. An integrated circuit package comprising:
   a side wall extending around a perimeter to define an interior region of the integrated circuit package forming a recess that is configured to hold an integrated circuit die and to define an exterior region of the integrated circuit package that is outside the side wall; and
   a flange coupled to an upper portion of the side wall to cantilever over the exterior region of the integrated circuit package.
Clause 70. The integrated circuit package of Clause 69 wherein the flange includes:
   a living hinge coupling an upper edge of the flange to the upper portion of the side wall, wherein the living hinge biases the flange to slope downward away from the side wall.
Clause 71. A garment comprising:
   a wearable textile
   a plurality electrical signal interconnects extending among the portions tailored for the respective body parts on the wearable fabric, the plurality of the electrical signal interconnects configured to conduct electrical signals among devices that are coupled to the wearable fabric, each of the electrical signal interconnects including:
      a first crease-able dielectric layer coupled to the wearable fabric;
      a crease-able electrically conductive layer on the first crease-able dielectric layer and configured to electrically conduct an electrical signal;
      a second crease-able dielectric layer on the crease-able electrically conductive layer opposite the first crease-able dielectric layer; and
      a plurality of electrical devices coupled to the wearable fabric and coupled to respective ones of the plurality electrical signal interconnects.
Clause 72. A stacked structure comprising:
   a flexible dielectric layer having a first surface and a second surface opposite the first surface;
   a first flexible electrically conductive layer defining a first serpentine pattern on the flexible dielectric layer including a plurality of first segments on the first surface of the flexible dielectric layer and including a plurality of second segments on the second surface of the flexible dielectric layer;
   a second flexible electrically conductive layer defining a second serpentine pattern on the flexible dielectric layer interlaced with the first serpentine pattern, the second flexible electrically conductive layer including a plurality of first segments of on the first surface of the flexible dielectric layer and including a plurality of second segments on the second surface of the flexible dielectric layer;
   a plurality of first vias passing through the flexible dielectric layer to connect the first and second segments of first serpentine pattern together; and
   a plurality of second vias passing through the flexible dielectric layer to connect the first and second segments of second serpentine pattern together.

### BRIEF DESCRIPTION OF THE DRAWINGS

Figures 1A-1D is a schematic illustration of various embodiments of textile products and garments according to the present invention having electrically functional devices attached thereon that are electrically coupled together by a plurality of transmission paths, provided for example, by respective stacked structures in some embodiments according to the invention.
Figure 2A is a cross-sectional schematic illustrating the layers in the stacked structure taken along line 2A-2A' in Figure 2E in some embodiments according to the invention.
Figure 2B is a cross-sectional schematic illustrating the layers in the stacked structure of Figure 2A taken along line 2B-2B' in Figure 2E in some embodiments according to the invention.
Figure 2C is a cross-sectional schematic illustrating the layers in the stacked structure taken along line 2C-2C' in Figure 2E including a portion of the deposited flexible conductive layer having a different width and thickness than that shown in Figure 2D in some embodiments according to the invention.
Figure 2D is a cross-sectional schematic illustrating the layers in the stacked structure taken along 2D-2D' in Figure 2E including a portion of the deposited flexible conductive layer having a different width and thickness than that shown in Figures 2A and 2C in some embodiments according to the invention.
Figure 2E is a perspective schematic illustration of a length of a stacked structure coupled to a substrate that is deformed to bend the stacked structure through a bending radius to form an angle in some embodiments according to the invention.
Figure 3 is a cross-sectional schematic illustrating a stacked structure including the first and second deposited flexible dielectric layers combined to surround the deposited flexible conductive layer and including the first and second deposited flexible conductive shield layers combined to surround the dielectric layers and the conductive layer in some embodiments according to the invention.
Figure 4A is a cross-sectional schematic illustrating a stacked structure including the first and second deposited flexible dielectric layers combined to surround the deposited flexible conductive layer and including the first and second deposited flexible conductive shield layers in some embodiments according to the invention.
Figure 4B is a cross-sectional schematic illustrating a stacked structure including a deposited flexible conductive layer on a deposited flexible dielectric layer and partially surrounded by a deposited flexible dielectric layer in some embodiments according to the invention.
Figure 4C is a cross-sectional schematic illustrating a stacked structure including a deposited flexible conductive layer on a deposited flexible dielectric layer and partially surrounded by a deposited flexible dielectric layer in some embodiments according to the invention.
Figure 4D is a cross-sectional schematic illustrating a stacked structure including a deposited flexible conductive layer into a dielectric layer and partially surrounded by a deposited flexible dielectric layer on the substrate in some embodiments according to the invention.
Figure 4E is a cross-sectional schematic illustrating a stacked structure including a deposited flexible conductive layer into a dielectric layer and partially surrounded by a deposited flexible dielectric layer on the substrate in some embodiments according to the invention.
Figure 5 is a cross-sectional schematic illustrating a stacked structure including a deposited flexible conductive layer on a first deposited flexible dielectric layer and partially surrounded by a second deposited flexible dielectric layer in some embodiments according to the invention.
Figure 6A is a cross-sectional schematic illustrating a stacked structure including a deposited flexible conductive layer on a first deposited flexible dielectric layer and partially surrounded by a second deposited flexible dielectric layer thereon all of which is partially surrounded by a deposited flexible conductive shield layer in some embodiments according to the invention.
Figure 6B is a cross-sectional schematic illustrating a stacked structure having an alternative geometry to that shown in Figure 6A including a deposited flexible conductive layer on a first deposited flexible dielectric layer and partially surrounded by a second deposited flexible dielectric layer thereon all of which is partially surrounded by a deposited flexible conductive shield layer in some embodiments according to the invention.
Figure 7 is a cross-sectional schematic illustrating a stacked structure including a deposited flexible conductive layer spaced between a pair of deposited flexible dielectric layers all of which is located between first and second deposited flexible dielectric layers in some embodiments according to the invention.
Figure 8 is a cross-sectional schematic illustrating a stacked structure including a deposited flexible conductive layer on a plurality of first deposited flexible dielectric layers and having a plurality of second deposited flexible dielectric layers thereon having different dielectric constants in some embodiments according to the invention.
Figure 9 is a cross-sectional schematic illustrating a stacked structure including a plurality of deposited flexible conductive layers spaced apart on a first deposited flexible dielectric layer and having a second deposited flexible dielectric layer thereon in some embodiments according to the invention.
Figure 10 is a cross-sectional schematic illustrating a stacked structure including a plurality of deposited flexible conductive layers spaced apart on a first deposited flexible dielectric layer and having a second deposited flexible dielectric layer where some of the deposited flexible conductive layers are designated as voltage reference layers with reference to the other deposited flexible conductive layers thereon in some embodiments according to the invention.
Figure 11 is a schematic illustration of a textile having first and second electrically functional devices attached, for example in the housing structures described herein, thereon and electrically coupled to one another by a pair transmission paths, for example of stacked structures, extending therebetween in some embodiments according to the invention.
Figure 12A is a cross-sectional schematic illustrating a stacked structure including a deposited flexible conductive layer on a first deposited flexible dielectric layer and having a second deposited flexible dielectric layer thereon in some embodiments according to the invention.
Figure 12B is a schematic illustrating the stacked structure of Figure 12A having the dielectric layers and the conductive layer coupled to a packaged integrated circuit device in some embodiments according to the invention.
Figure 13A is a cross-sectional schematic illustrating a stacked structure including a plurality of deposited flexible conductive layers spaced apart on a first deposited flexible dielectric layer and having a second deposited flexible dielectric layer thereon in some embodiments according to the invention.
Figure 13B is a schematic illustrating the stacked structure of Figure 13A having the dielectric layers and the conductive layers coupled to an electrically functional device in some embodiments according to the invention.
Figure 14 is a cross-sectional schematic illustrating a stacked structure including a substrate with a through-connect therein and a deposited flexible conductive layer positioned over the opening beneath the substrate in some embodiments according to the invention.
Figure 15 is a cross-sectional schematic illustrating a stacked structure including a deposited flexible conductive shield layer a substrate with a through-connect therein and a deposited flexible conductive layer and a deposited flexible dielectric layer both positioned over the opening and beneath the substrate in some embodiments according to the invention.
Figure 16 is a cross-sectional schematic illustrating a stacked structure on a substrate having a hole therein and a deposited flexible conductive layer positioned over the hole beneath the substrate, the stacked structure further includes a first deposited flexible dielectric layer having a hole therein positioned beneath a deposited flexible conductive layer in some embodiments according to the invention.
Figure 17 is a cross-sectional schematic illustrating a stacked structure on a substrate having a hole therein and a deposited flexible conductive layer positioned over the hole beneath the substrate, the stacked structure further includes a deposited flexible dielectric layer with a hole therein and first and second deposited flexible conductive layers positioned to cover the hole above and below in some embodiments according to the invention.
Figure 18A is a schematic illustration of a fabric including a plurality of conductive threads woven into a plurality of dielectric threads.
Figure 18B is a detailed view of section A shown in Figure 18A including one of the conductive threads woven into the plurality of dielectric arms by alternatingly passing over opposite surfaces of directly adjacent ones of the dielectric threads.
Figure 18C is an illustration of a knitted fabric including a plurality of conductive threads integrated therein with a plurality of dielectric threads.
Figure 18D is an illustration of a fabric including a plurality of non-woven conductive threads integrated therein with a woven inlay of plurality of dielectric threads.
Figure 19A is a cross-sectional schematic illustrating the woven conductive thread shown in Figures 18A and 18B having deposited flexible dielectric and conductive shield layers coupled to the first and second opposing surfaces of the fabric in some embodiments according to the invention.
Figure 19B is a cross-sectional schematic illustrating the woven conductive thread shown in Figures 18A and 18B having deposited flexible dielectric layers coupled to the first and second opposing surfaces of the fabric in some embodiments according to the invention.
Figure 20A is a perspective schematic illustrating a looped stacked structure extending on a substrate to form inductive elements in some embodiments according to the invention.
Figure 20B is a cross-sectional schematic illustrating the looped stacked structure shown in Figure 20A in some embodiments according to the invention.
Figure 20C is a cross-sectional schematic illustrating details of the looped stacked structure shown in Figure 20B in some embodiments according to the invention.
Figure 21A is a schematic plan view of a pair of serpentine patterns intertwined with one another to provide a twisted pair conductor wherein each of the serpentine patterns includes a plurality of first and second deposited flexible conductive segments on opposing surfaces of a fabric to cross over one another in some embodiments according to the invention.
Figure 21B is a cross-sectional schematic illustrating the structure shown in Figure 21A taken along line 21B-21B' in Figure 21A in some embodiments according to the invention.
Figure 22 is a cross-sectional schematic illustrating details of the regions O and U shown in Figure 21B in some embodiments according to the invention.
Figure 23 is a schematic illustrating a housing structure in an upside-down orientation configured to hold a packaged integrated circuit device inserted into the housing structure via an opening located remote from a hinge portion of a flange coupled to the side wall in some embodiments according to the invention.
Figure 24 is a schematic illustrating a housing structure in a right side up orientation wherein the opening to the recess is located proximate to the hinge portion of the flange in some embodiments according to the invention.
Figures 25A-25F are plan views of various housing structure features configured to secure the flange to a substrate in some embodiments according to the invention.
Figures 26A is a schematic plan view of a housing structure illustrating a plurality of pads extending through the side wall of the flange and extending around the perimeter in some embodiments according to the invention.
Figure 26 B is a cross-sectional schematic illustrating the cross-section of the housing structure shown in Figure 26A taken along line 26B-26B' in some embodiments according to the invention.
Figure 26C is a cross-sectional schematic illustrating a cross section of a portion of the sidewall of the housing structure where a pad of the housing structure passes through the sidewall to contact components mounted on a printed circuit board coupled to an integrated circuit package secured in the recess in some embodiments according to the invention.
Figure 27 is a cross-sectional schematic illustrating the housing structure mounted on a substrate with the side wall and the pads visible through the flange in some embodiments according to the invention.
Figure 28 is a cross-sectional schematic illustrating the housing structure mounted on a surface of the fabric with the side wall and the pads visible through the flange and stacked structures deposited on the fabric and electrically coupled to surfaces of the pads in some embodiments according to the invention.
Figure 29 is a cross-sectional schematic illustrating the housing structure mounted on a surface of the fabric with the sidewall and the pads visible through the flange and showing a deposited flexible conductive layer embedded within the fabric and electrically coupled to surfaces of the pads in some embodiments according to the invention.
Figure 30 is a cross-sectional schematic illustrating the housing structure mounted on the surface of the fabric with the sidewall and the pads visible through the flange and showing a stacked structure including deposited flexible conductive and dielectric layers embedded within the fabric and electrically coupled to surfaces of the pads in some embodiments according to the invention.
Figure 31 is a cross-sectional schematic illustrating the housing structure mounted on a fabric including conductive and dielectric threads woven into the fabric and having deposited flexible dielectric layers coupled to the surfaces of the fabric in some embodiments according to the invention.
Figure 32 is a cross-sectional schematic illustrating the housing structure mounted on a fabric including conductive and dielectric threads woven into the fabric and having deposited flexible dielectric and conductive shield layers coupled to the surfaces of the fabric in some embodiments according to the invention.
Figure 33 is a cross-sectional schematic illustrating the housing structure mounted on a substrate including a packaged integrated circuit device secured in the recess in an upside down orientation where the leads of the packaged integrated circuit device are positioned proximate to the hinge portion of the flange when inserted into the recess and the housing structure is open at the top to expose the lower surface of the packaged integrated circuit device in some embodiments according to the invention.
Figure 34 is a cross-sectional schematic illustrating the housing structure mounted on a substrate including a packaged integrated circuit device secured in the recess in an upside down orientation with a heat sink mounted to the lower surface of the packaged integrated circuit device and the leads of the packaged integrated circuit device positioned proximate to the hinge portion of the flange and the housing structure being open at the top to expose the heat sink or couple with an external heat sink in some embodiments according to the invention.
Figure 35 is a cross-sectional schematic illustrating the housing structure mounted on a substrate including a packaged integrated circuit device secured in the recess in an upside-down orientation where the top of the housing structure is closed over the lower surface of the packaged integrated circuit device in some embodiments according to the invention.
Figure 36 is a cross-sectional schematic illustrating the housing structure mounted on a substrate including a packaged integrated circuit device secured in the recess in a right side up orientation where the leads of the packaged integrated circuit device are positioned remote from the hinge portion of the flange when inserted into the recess where the top of the housing structure is open to expose an upper surface of the packaged integrated circuit device in some embodiments according to the invention.
Figure 37 is a cross-sectional schematic illustrating the housing structure mounted on a substrate where the housing structure includes a lip located at an upper portion of the flange proximate to the hinge portion configured to secure the packaged integrated circuit device in the recess and to expose an upper surface of the packaged integrated circuit device in some embodiments according to the invention.
Figure 38 is a cross-sectional schematic illustrating the housing structure mounted on a substrate where the housing structure includes a closed top portion to cover the upper surface of the packaged integrated circuit device in the recess in some embodiments according to the invention.
Figure 39 is a cross-sectional schematic illustrating the housing structure mounted on a fabric where the housing structure includes a prong lead that extends from the sidewall of the housing structure and pierces the fabric to extend to a lower surface of the fabric that is opposite the surface where the housing structure is mounted to secure the housing structure to the fabric in some embodiments according to the invention.
Figure 40 is a cross-sectional schematic illustrating the housing structure mounted on a fabric where the housing structure includes a prong lead that is coupled to a pad of the housing structure and pierces the fabric to extend to a lower surface of the fabric that is opposite the surface where the housing structure is mounted to electrically couple a deposited flexible conductive layer within the fabric to the pad in some embodiments according to the invention.
Figure 41 is a cross-sectional schematic illustrating the housing structure mounted on a fabric where the housing structure includes a prong lead that is coupled to the pad of the housing structure and pierces the fabric to extend to a lower surface of the fabric that is opposite the surface where the housing structure is mounted to electrically couple a deposited flexible conductive layer on the lower surface to the fabric to the pad in some embodiments according to the invention.
Figure 42 is a cross-sectional schematic illustrating the housing structure mounted on a fabric where the housing structure includes rivets that extend through the tail portion of the flange to secure the housing structure to the fabric in some embodiments according to the invention.
Figure 43 is a cross-sectional schematic illustrating the housing structure mounted on a fabric where the housing structure includes a prong lead that is coupled to a pad of the housing structure as shown in Figures 39-41 in some embodiments according to the invention.
Figure 44 is a cross-sectional schematic illustrating the housing structure mounted on a substrate including a packaged integrated circuit device secured in the recess in an upside-down orientation as shown in Figure 35 with a lens and/or filter coupled to a lower surface of the packages integrated circuit device in some embodiments according to the invention.
Figure 45 is a cross-sectional schematic illustrating the housing structure mounted on a substrate including a packaged integrated circuit device secured to a PCB in the recess in an upside-down orientation in some embodiments according to the invention.
Figure 46 is a cross-sectional schematic illustrating the housing structure mounted on a substrate including a packaged integrated circuit device secured to a PCB in the recess in an upside-down orientation in some embodiments according to the invention.
Figure 47A is a plan view schematic illustrating deposited flexible dielectric layers and deposited flexible conductive layers on a plurality of capacitors in some embodiments according to the invention.
Figure 47B is a perspective schematic illustrating deposited flexible dielectric layers and deposited flexible conductive layers on a plurality of capacitors in some embodiments according to the invention.
Figure 47C is a cross-sectional schematic illustrating the deposited flexible dielectric layers and the deposited flexible conductive layers on a plurality of capacitors taken along line C-C' shown in Figure 47A in some embodiments according to the invention.

### DETAILED DESCRIPTION OF EMBODIMENTS ACCORDING TO THE INVENTION

The invention is described herein with reference to the accompanying drawings. The invention may, however, be embodied in many different forms and should not be construed as limited to the embodiments set forth herein; rather, these embodiments are provided so that this disclosure will be thorough and complete, and will fully convey the scope of the invention to those skilled in the art. Like numbers refer to like elements throughout.

As appreciated by the present inventor, materials such as conductive nanoparticles, conductive flakes, conductive polymers, conductive fibers, or conductive filaments, may shift during use or movement of the flexible substrate due to substrate deflections, which can adversely affect the integrity of an electrical signal carried by those materials. Similarly, woven, knitted, embroidered, and non-woven conductive threads, fibers, and filaments may have properties that can adversely affect the integrity of an electrical signal carried by those materials.

For example, in a textile-based system the voltage level of a signal transmitted using these materials can be degraded when the substrate on which the materials are deposited is deformed, for example, during deposition or when the wearer moves. Accordingly, embodiments of the present invention can provide stacked structures to mitigate the effects on the signal integrity, such as unintended voltage fluctuations, due to those deformations and from unintended voltage fluctuations originating from the environment such as Wi-Fi signals, cell tower signals, radar signals, light signals, and movement/manipulation of the flexible substrate.

As further appreciated by the present inventor, the particle, polymeric, and fibrous nature of materials that can be used to form transmission paths on a textile, such as electronic inks and coated threads, can lead to changes in the impedance of the conductive pattern upon deformation. For example, if a fabric using these materials is deformed, then the voltage levels of the transmitted signals can be altered which can result in inaccurate data being transmitted. Also appreciated by the present inventor is the repeated flexibifity for the comfort, convenience, and spatial versatility of textiles. For example, in some embodiments, a shirt and a tent may be compacted into a backpack then expanded to a larger form dozens of times. Further appreciated by the present inventor is the environmental interaction of both textiles and electrical signals for the use of permeable, semi-permeable, controllably-permeable, and non-permeable barriers. For example, in some embodiments, a rainproof fabric may be layered on a fully conductive fabric to create a barrier that is impermeable to raindrops and radio signals. Or a heat barrier fabric may be layers on a radio-absorbing fabric to create a barrier to both heat and radio waves.

In some embodiments, the layers (such as the conductive and the dielectric layers) in the stacked structures can be deposited onto one another as layers of specified cross-sectional thicknesses and widths so that the stacked structures can address the signal integrity effects described herein. In some embodiments, the materials can include conductive nanoparticles or polymers, such as functional inks, which can be deposited as layers onto the substrate to have specified dimensions and in specified arrangements as described herein. By layering the nanoparticle and/or polymeric functional inks, embodiments according to the invention can provide transmission paths for signals in a textile based system while reducing the impact of signal degradation resulting from deformation of the textile and various other interference.

In some embodiments according to the invention, a first layer can include conductive nanoparticles, a second layer can include dielectric nanoparticles, another layer of conductive nanoparticles can be formed on the second layer, and so forth. These layers can serve different functions, such providing electrical coupling to a larger devices' ground reference or specific components like ADCs, sensors, and emitters (such as haptic, sonic, light, IR, radar emitters).

Additionally, the pattern widths and thicknesses of these layers can be controlled to match resonant frequencies of the patterns that couple circuits to one another, which can reduce signal integrity.

In some embodiments, the layers of the stacked structures can be formed to provide antennas to manage, for example, the adverse voltage changes that can occur between the antenna and a receiver circuit due to the deformation of the substrate. In some embodiments of the present invention involves applying multiple layers of ink to a substrate.

For signal stabilization, dielectric and conductive patterns can be layered onto woven, non-woven, or knitted textiles which include conductive and dielectric threads that are woven, knitted, embedded, deposited, or attached into fabric structures. These threads can carry ground references, voltages, or data signals.

As further appreciated by the present inventor, embodiments according to the present invention, can be used to enhance the reliability of data and power traces in textile and flexible electronics. For example, in some embodiments according to the present invention, a housing_structure can be formed of conductive particle-filled polymers and dielectric polymers to couple integrated circuits (ICs) and other electric components to a flexible or crease-able, or otherwise deformable substrates, such as a textile used in a garment. In still further embodiments according to the invention, the housing structures can be formed to include conductive particle-filled polymers arranged in the housing structure to align with specified IC input/output patterns so that when an IC is inserted into the housing structure, the input/output signals to/from the IC can be securely coupled to the conductive patterns on a textile. In some embodiments, the housing structure can be coupled to the textile by mechanical structures or chemical bonds created as part of manufacturing, application, or deposition process. It will be understood that housing structures according to embodiments of the present invention can be configured to accept various IC packages, including 3D heterogeneous integration chiplets, and the like. In some embodiments, the housing structure can be configured to accept data input or output through optically conductive threads. In some embodiments, the housing structure can reduce water or moisture intrusion into the circuitry. In some embodiments the housing structure can include a fabric-embedded composite.

In still further embodiments according to the invention, the housing structures can be a socket structure that can be configured to hold an integrated circuit in, for example, an upside-down or right side up orientation where conductive particle-filled polymers arranged in the socket structure can align with specified IC input/output patterns so that when an IC is inserted into the housing structure, the input/output signals to/from the IC can be securely coupled to the conductive patterns on a textile. In still further embodiments according to the invention, the housing structures, stacked structures, methods and circuits described herein can be used to couple multiple devices together to provide stable data communications for the devices.

As further appreciated by the present inventor, embodiments according to the invention can also be applied to film-based, deformable substrate, such as vacu-form films or Kapton and rigid materials such as fiberglass composite, wood, glass, metal, ceramic, and plastic.

As used herein, the term "garment" refers to an item or combination of items worn or carried by a person or an animal including one or more of the following: top, bottom, undergarment, harness, accessory such as gloves, gauntlet, anklet, bracelet, belt, fanny pack, purse, backpack, apron, and similar other items, headwear such as headband, full or partial balaclava, hat, helmet, and similar other items, or footwear such as socks, shoes, boots, and similar other items in some embodiments according to the invention.

As used herein, the phrase "integrated into" can refer threads, such as conductive threads or dielectric threads, that are woven, knitted, or embroidered into a fabric, which can have deposited flexible dielectric layers and deposited flexible conducive shield layers attached thereto in some embodiments according to the invention.

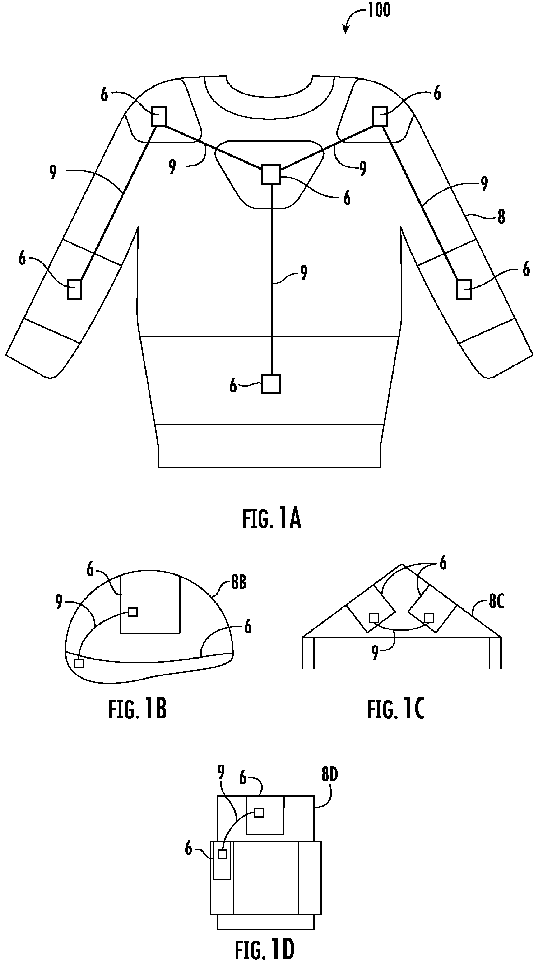

Figures 1A-1D are schematic illustrations of various embodiments of garment 8 according to the present invention having electrically functional devices 6 attached thereon that are electrically coupled together by a plurality of transmission paths 9, provided for example, by respective stacked structures in some embodiments according to the invention. The devices 6 can include any electronic circuit suitable for use in the system 100. For example, the devices 6 can be sensors, displays, processor circuits, RF transmitter circuits, RF receiver circuits, RF damper structures, RF reflector structures, RF absorber structures, photonic receivers, photonic transmitters, FPGAs, and ASICs data interface circuits, and/or power supplies. Other devices may also be included. Still further, the transmission paths 9 can be used for point-to-point communications between devices 6, a daisy-chained topology, a bus topology, a P2P topology, a star topology, a ring topology, a mesh topology, a tree topology, an endpoint topology, or other topology. As further shown in Figures 1A-1D, the garment can take the form, for example, of a helmet shown in Figure 1B, a tent as shown in Figure 1C, and a backpack as shown in Figure 1D.

The transmission paths 9 can also be formed into passive elements, such as antennas, which or may not be coupled to electrically functional devices 6. In some embodiments according to the invention, the transmission paths can transmit data in a serial format. In some embodiments according to the invention, the transmission paths can transmit data in a parallel format. In some embodiments according to the invention, the transmission paths can convert energy to mechanical energy.

In operation, the devices can operate with one another to perform the functions specified by the system 100. For example, the system may include a group of sensors configured to monitor the wearer's body functions, which may entail transmitting data from or among a group of sensors to local or remote processing circuits using the transmission paths 9.

As shown in Figures 1A-1D, the electrically functional devices 6 are distributed among different portions of the garment 8. When the wearer moves, the different portions of the garment 8 can move relative to one another, such as when the wearer raises their arms to lift an object. This movement can cause one or more of the transmission paths 9 to deform in multiple dimensions, which can change the characteristics of the transmission path 9 due to the characteristics of the materials used to form the transmission path 9. For example, when the transmission paths 9 deforms, the impedance of the transmission path can change such that data transmitted over the transmission path may be corrupted unless steps are taken to compensate for the changes in the transmission path characteristics as described herein, through the stacked structures.

In some embodiments according to the invention, the transmission paths 9 can be a stacked structure including deposited flexible dielectric layers, deposited flexible conductive layers and deposited flexible conductive shield layers that are coupled to the upper and lower surfaces of a fabric woven with conductive and dielectric threads, composites, or film-based layers, as described for example in reference to Figures 1-17. It will be understood that the stacked structures can include other layers and features in some embodiments. These stacked structures can be attached to or embedded in the garment 8 to provide the transmission path 9.

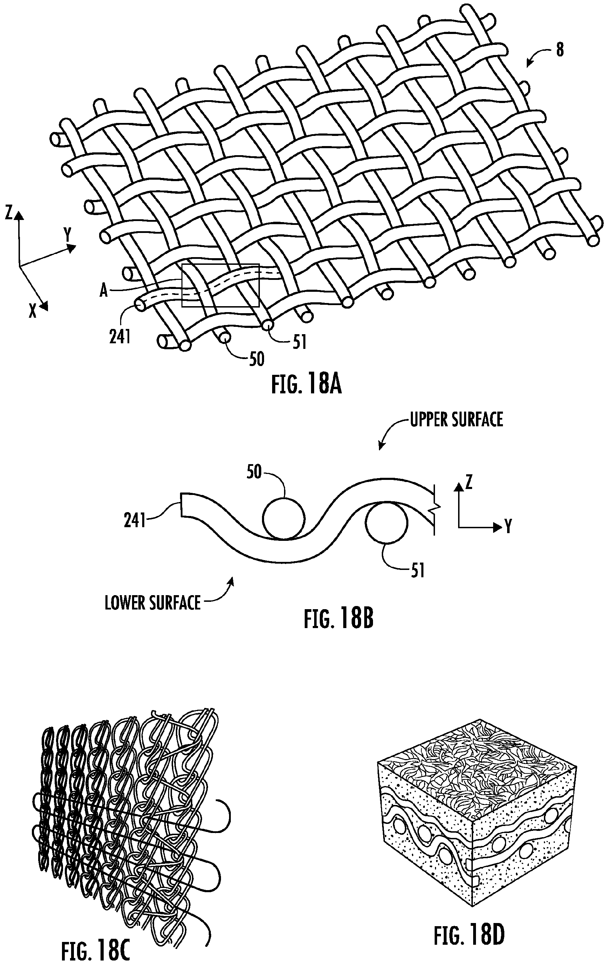

In some embodiments according to the invention, the transmission paths 9 can be a flexible electrical conductor that can include deposited flexible dielectric layers that are coupled to the upper and lower surfaces of a fabric that is woven with conductive and dielectric threads, as described for example in reference to Figures 18-19. In some embodiments according to the invention, the flexible electrical conductor can be deposited flexible conductive shield layers. It will be understood that the flexible electrical conductors can include other layers and features in some embodiments.

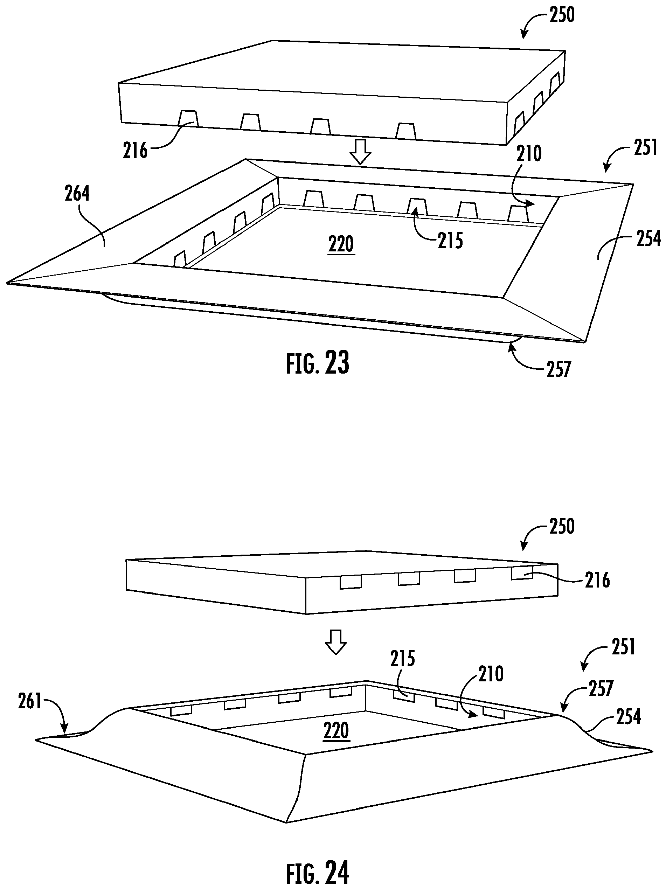

It will be further understood that the devices 6 can be attached to the garment 8 using the housing and housing structures described, for example, in reference to Figures 23- 42. In such embodiments, the devices 6 can be inserted into the housing structures which may, in turn, be coupled to the garment 8. Once the housing structures are coupled to the garment 8, the signals can be provided to the devices 6 over the transmission paths 9 connect the housing structure which is coupled to the packaged integrated circuit device. Alternatively, in some embodiments according to the invention, the housing structures may be already coupled to the garment 8 when the devices 6 are inserted into the housing structures whereupon the leads of the devices 6 are electrically coupled to the transmission paths 9 by the housing structure on the garment 8.

In some embodiments according to the invention, the deposited flexible conductive layers in each of the embodiments described herein can be formed of a conductive ink layer, a silver nanoparticle, a copper nanoparticle ink or the like. In some embodiments according to the invention, the deposited flexible conductive layer can be a conductive ink available from Bare Conductive Paint. In some embodiments according to the invention, the deposited flexible conductive layer can be a silver nanoparticle such as Nagase CI-1036 or DuPont MicroMax PE876. In some embodiments according to the invention, the deposited flexible conductive layer can be a copper nanoparticle ink, such as Copprium 3000 Series. In some embodiments according to the invention, the deposited flexible conductive layer can be a thread woven or embroidered into a Burlington Textiles Barrier Fabric. In some embodiments according to the invention, the deposited flexible conductive layer can be a VOLT Wearable Technology Yarn created by Supreme Corporation or Orgacon PEDOT:PSS by AGFA.

In some embodiments, the deposited flexible conductive layers may comprise materials that exhibit resistivity values of, for example, less than 10⁻² Q-m, less than 10⁻⁴ Ω·m, less than 10⁻⁵ Ω·m, less than 10⁻⁶ Ω·m, less than 10⁻⁷ Ω·m, less than 2.0×10⁻⁸ Ω·m or less than 1.7×10⁻⁸ Ω·m. In each of these cases, the lower resistivity value can be considered to be greater than 0 Ω·m. In some embodiments according to the invention, the resistance of the material may be greater than 1 Ω·m and less than 100MΩ·m or may change based on the deformed position of the textile. The materials in the deposited flexible conductive layers may be metallic or nonmetallic and may include polymeric materials or conductive-filled polymeric materials. To this end, any material having a suitable degree of conductivity for a given application can be used for the flexible conductive layers. Example metals include, for example, silver, copper, gold, aluminum, platinum, lead, and iron. The conductive material may also be an alloy or may be a doped metal.

In some embodiments, if referred to as a conductive polymer, the deposited flexible conductive layer may include a dopant or additive such as iodine, carbon black, or metal conductor nanoparticle or nanoflake. In some embodiments the flexible conductive layer may be a translucent or transparent material. These materials include, for example, transparent conductive oxides (TCO) such as tin-doped indium-oxide, aluminum-doped zinc-oxide (AZO) and indium-doped cadmium-oxide. Transparent or translucent conductive polymeric materials include, for example, polymers containing thiophenes such as poly(3,4-ethylenedioxythiophene) (PEDOT), PEDOT with poly(styrene sulfonate) (PSS) and poly(4,4-dioctylcyclopentadithiophene). In transverse cross-section, the conductive layers may be substantially rectangular and may have an average thickness and/or width from 10 nm to 100 µm, 100 nm to 10 µm, or 100 nm to 100 µm, in some embodiments. In some embodiments according to the invention, the deposited flexible dielectric layer as a polymer can be PVC-based Plastisol inks from Xenon Products.

In some embodiments according to the invention, the deposited flexible conductive layers can have a thickness in a range between about .005 mm to about 4.0 mm. In some embodiments according to the invention, the deposited flexible conductive layers can have a width in a range between about .01 mm to about 60 mm.

In some embodiments according to the invention, the deposited flexible dielectric layers in each of the embodiments described herein can be formed of polymer ink, elastomeric urethane, elastomeric silicone, plasticized acrylic, solvent-disperse polymers or the like. In some embodiments, according to the invention, the deposited flexible dielectric layers can include a low-k flexible dielectric material, or any other suitable dielectric material capable of providing the desired flexibifity and insulative effect including high-k dielectrics as well as dielectric materials having a dielectric constant on par with silicon dioxide. The materials used may exhibit a dielectric constant (k) of, for example, less than 3.9, less than 3.5 or less than 3.0, in some embodiments. The deposited flexible dielectric layers may have a substantially rectangular or trapezoidal shaped cross-section. A dielectric layer can be formed from materials including porous silicon dioxide and silicon dioxide doped with fluorine and/or carbon. Other example dielectric materials include polymer dielectrics including spin-on organic polymeric dielectrics such as hydrogen silsesquioxane (HSQ) and methyl silsesquioxane (MSQ), polyimide, polynorbornenes, benzocyclobutene, and PTFE. Additional example polymeric dielectrics may be made from cyclic carbosilanes. In some embodiments, the dielectric layers can include a high-k dielectric material such as hafnium oxide, hafnium silicon oxide, nitrided hafnium silicates, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. The dielectric may be porous or non-porous. In some embodiments according to the invention, the deposited flexible dielectric layer can be Sun Chemical D2070209P6

In some embodiments according to the invention, the deposited flexible dielectric layers can have a thickness in a range between about .005 mm to about 4 mm. In some embodiments according to the invention, the deposited flexible dielectric layers can have a width in a range between about .01 mm to about 420 mm.

In some embodiments according to the invention, the deposited flexible conductive shield layers in each of the embodiments described herein can be formed of DuPont MicroMax PE876 or Nagase CI-1036. In some embodiments according to the invention, the deposited flexible conductive shield layers can have a thickness in a range between about .001mm to about .1mm. In some embodiments according to the invention, the deposited flexible conductive shield layers can have a width in a range between about .3mm to about 421mm.

As used herein, the term "flexible" in relation to the deposited layers (such as the deposited flexible conductive layers, the deposited flexible dielectric layers, and the deposited flexible conductive shield layers and the stacked structures and fabrics incorporating these layers, sometimes referred to herein collectively as layers or structures) are characterized as being easily bendable, similar to a natural or synthetic non-electrically functional fiber. For example, the flexible layers, stacked structures, and electrical conductors incorporating deposited flexible layers described herein may exhibit a natural bending radius of less than about 2 mm, less than about 1 mm or less than about 0.5 mm. The natural bending radius of an electrically functional layer or structure is the radius of the smallest cylinder that the layer or structure can be wrapped around without losing its intended electrical capability. The flexibifity of a functional layer or structure can also be mechanically evaluated similarly to the way textile fibers are evaluated for flexibility. For example, in some embodiments a functional layer or structure can exhibit a flexibifity (I/MR) greater than (more flexible than) that of a nylon fiber having a diameter equal to, or 1.1×, 1.2×, 1.5×, 2.0× or 3.0× the thickness of the functional layer or structure. In some embodiments, the functional layer or structure can be bent more tightly than a comparable nylon fiber and still maintain its intended electrical functionality. In some embodiments, a functional layer or structure can endure significant bending without losing its electrical properties. For example, the functional layer or structure can bend in multiple dimensions, adapting to various shapes and movements. In some embodiments, even when subjected to tight bends and twists, a functional layer or structure can continue to perform effectively, ensuring consistent electrical performance.

It will be further understood that the deposited flexible layers or structures in some embodiment according to the invention can be formed by depositing layers on a substrate, such as a fabric, or the like. In some embodiments according to the invention, the deposited layers can be printed by, for example, extrusion printing, inkjet printing, screen printing, additive printing (such as 3D printing), laminations, roll-to-roll printing, weaving, knitting, or embroidery. Other processes may also be used.

In some embodiments according to the invention, the deposited flexible layers can be formed in a sequence starting with a layer that is to be directly in contact with the substrate. For example, a deposited flexible conductive shield layer may be formed on a substrate followed by formation of a lower deposited flexible dielectric layer, a deposited flexible conducive layer, an upper deposited flexible dielectric layer, and an upper deposited flexible conductive shield layer. In some embodiments according to the invention, a number of the deposited flexible layers can be formed on an upper side of a substrate, and the partially formed structure may be inverted so that other deposited flexible layers can be formed on a lower side of the substrate. In some embodiments according to the invention, some of the deposited flexible layers can be formed on an upper side of a substrate, and the other deposited flexible layers can be formed on the lower side of the substrate by inverting the mechanism configured to form the deposited flexible layers. Other processes may also be used.

As used herein, the term "creaseable" in relation to the deposited layers, the stacked structures, and the flexible electrical conductors including the deposited layers are characterized as being easily bendable, similar to a natural or synthetic non-electrically functional fiber to form a persistent line or ridge in a fabric having the stacked structures and/or flexible electrical conductors include therewith in some embodiments according to the invention. For example, creaseable layers, stacked structures, or electrical conductors incorporating deposited flexible layers described herein may exhibit a natural bending radius such that those creaseable layers, stacked structures, or electrical conductors can be folded back on itself (e.g., to form an angle of about 180 degrees without losing its intended electrical capability.

It will be further understood that although the figures herein may illustrate the layers included in the stacked structures and flexible electrical conductors according to the invention, as idealized versions of the layers including, for example, generally planar upper and lower surfaces, those surfaces may not be completely flat and may exhibit, for example, variations from the ideal due to the effects resulting from deposition of the layers themselves as well as the effects resulting from other layers in the structure, such as step-height differences induced by underlying layers. In some embodiments according to the invention, the thickness of the layers may change in response to a process that cures the deposited layers.

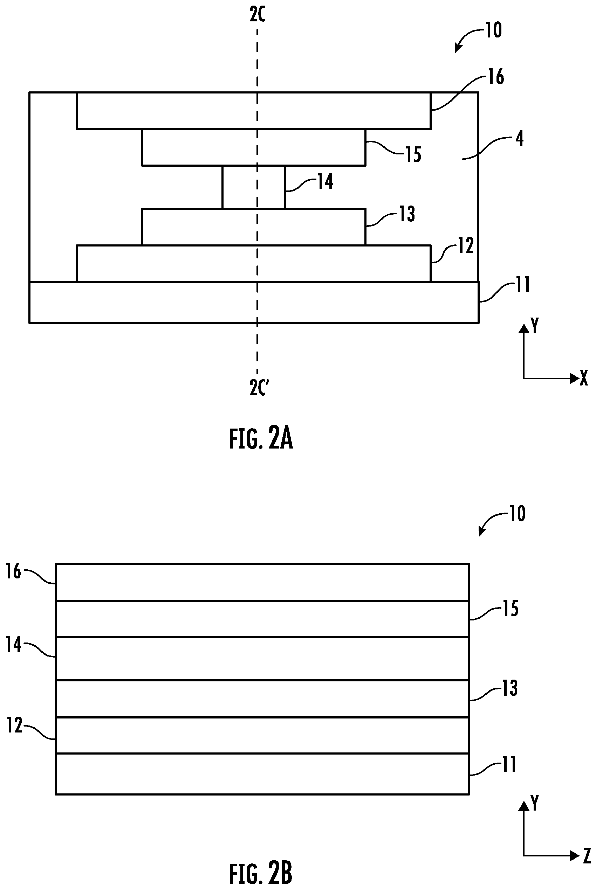

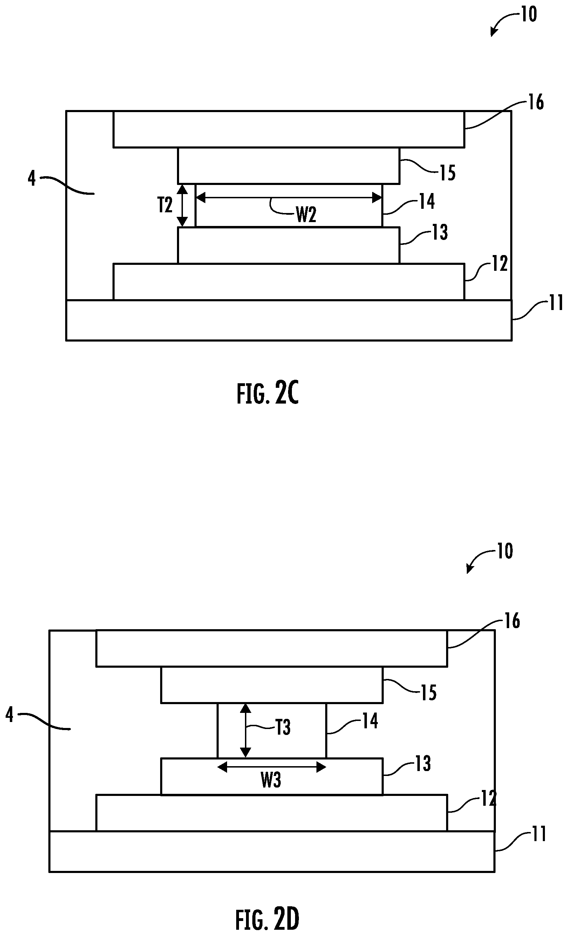

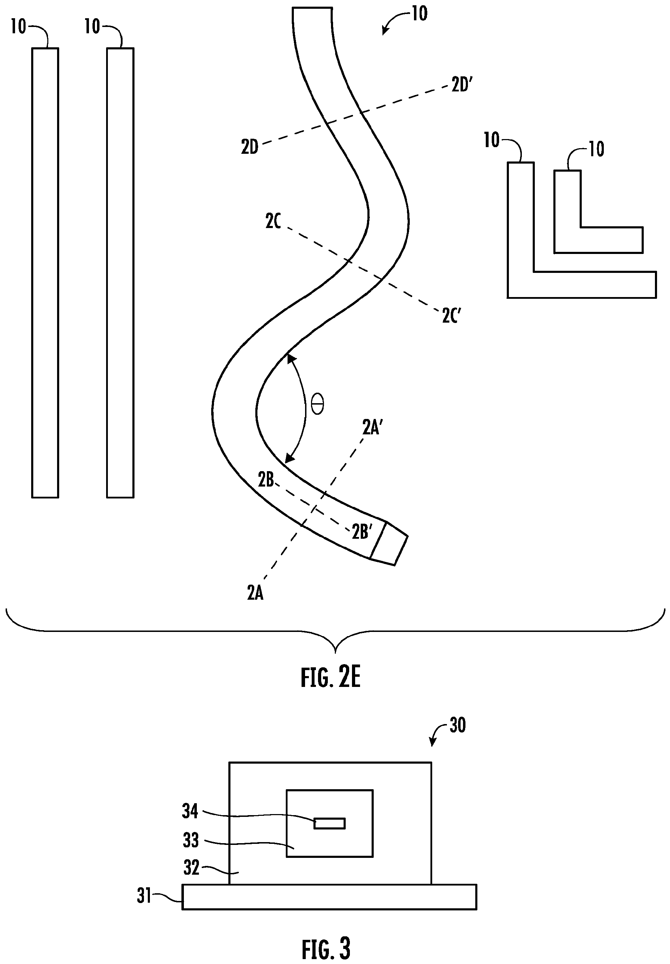

Figure 2A is a cross-sectional schematic illustrating the layers in the stacked structure 10 taken along line 2A-2A' in Figure 2E in some embodiments according to the invention. Figure 2B is a cross-sectional schematic illustrating the layers in the stacked structure 10 of Figure 2A taken along line 2B-2B' in Figure 2E in some embodiments according to the invention. Figure 2C is a cross-sectional schematic illustrating the layers in the stacked structure 10 taken along line 2C-2C' in Figure 2E (or 2A) including a portion of the deposited flexible conductive layer 14 having a different width and thickness than that shown in Figure 2D in some embodiments according to the invention. Figure 2D is a cross-sectional schematic illustrating the layers in the stacked structure taken along 2D-2D' in Figure 2E including a portion of the deposited flexible conductive layer 14 having a different width and thickness than that shown in Figures 2A and 2C in some embodiments according to the invention. Figure 2E is a perspective schematic illustration of a length of a stacked structure 10 coupled to a substrate that may be deformed to bend the stacked structure through a bending radius to form an angle Θ in some embodiments according to the invention.

According to Figure 2A, a substrate 11 can be a rigid material, a flexible material such as a fabric, PET, paper, or the like and may include patterned conductive materials to be used in conjunction with the stacked structure 10 formed thereon. Each of the layers formed on the substrate 11 has a respective width in the X direction and a respective thickness in the Y direction. It will be further understood that although widths and thicknesses of each of the layers are shown, the relative widths and thicknesses of the layers are not necessarily to scale.

A deposited flexible conductive shield layer 12 is formed on the substrate 11 and a deposited flexible dielectric layer 13 is formed on the deposited flexible conductive shield layer 12. A deposited flexible conductive layer 14 is formed on the deposited flexible dielectric layer 13 followed by the formation of a deposited flexible dielectric layer 15 and a deposited flexible conductive shield layer 16.

As shown in Figure 2A, the width of the deposited flexible conductive layer 14 can be less than the respective widths of each of the deposited flexible dielectric layers 13 and 15 in some embodiments according to the invention. Furthermore, the widths of the deposited flexible dielectric layers 13 and 15 can be less than those of the deposited flexible conductive shield layers 12 and 15 in some embodiments according to the invention. In some embodiments according to the present invention, a filler material 7 can be added. In some embodiments according to the present invention, the filler material can be a low-k flexible dielectric polymer.

Figure 2B is a cross-sectional schematic illustrating the layers in the stacked structure 10 taken along line 2B-2B' in Figure 2E including a portion of the deposited flexible conductive layer having a different width and thickness than that shown in Figure 2A in some embodiments according to the invention. Figure 2D is a cross-sectional schematic illustrating the layers in the stacked structure 10 taken along 2D-2D' in Figure 2E including a portion of the deposited flexible conductive layer having a different width and thickness than that shown in Figures 2A and 2C in some embodiments according to the invention.

Referring to Figures 2A, 2C and 2D, it will be understood that the layers, such as the deposited flexible conductive layer 14 included in the stacked structure 10 can have varied thickness and width along the length of the stacked structure 10 shown in Figure 2A. In particular, as shown in Figure 2C at the point in the length of the stacked structure 10 corresponding to the cross section shown in Figure 2C, the deposited flexible conductive layer 14 can have a width of W1 and a thickness of T2 whereas at the point in the length of the stacked structure 10 corresponding to Figure 2D, the deposited flexible conductive layer 14 has a width W3 and a thickness T3. Accordingly, it will be understood that the layers in the stacked structure 10 may have varied thickness and width along the length of the stacked structure 10 such as when the stacked structure 10 is used to connect a transmitter circuit to a receiver circuit.

Figure 3 is a cross-sectional schematic illustrating a stacked structure 30 including a combined first and second deposited flexible dielectric layer 33 surrounding the deposited flexible conductive layer 34 in some embodiments according to the invention. According to Figure 3, a substrate 31 can be a rigid material, a flexible material such as a fabric, PET, paper, or the like and may include patterned conductive materials to be used in conjunction with the stacked structure 30 formed thereon. Each of the layers formed on the substrate 31 has a respective width in the X direction and a respective thickness in the Y direction. It will be further understood that although widths and thicknesses of each of the layers are shown, the relative widths and thicknesses of the layers are not necessarily to scale.

According to Figure 3, a combined first and second deposited flexible dielectric layer 33 is formed to fully surround a deposited flexible conductive layer 34. A combined first and second deposited flexible conductive shield layer 32 is formed to fully surround the combined first and second deposited flexible dielectric layer 33 and to fully surround the deposited flexible conductive layer 34 in some embodiments according to the invention. In some embodiments according to the invention, any or all of the deposited flexible dielectric layers can include a piezoelectric material.

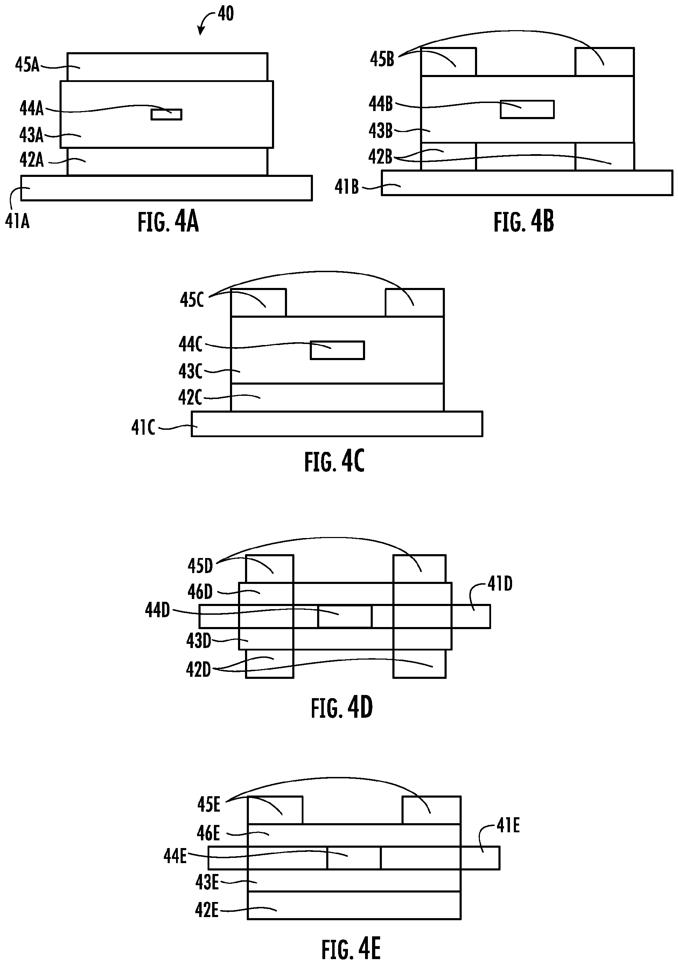

Figure 4A is a cross-sectional schematic illustrating a stacked structure 40A including a combined first and second deposited flexible dielectric layer 43A formed to surround a deposited flexible conductive layer 44A in some embodiments according to the invention. According to Figure 4A, a substrate 41A can be a rigid material, a flexible material such as a fabric, PET, paper, or the like and may include patterned conductive materials to be used in conjunction with the stacked structure 40A formed thereon. Each of the layers formed on the substrate 41A has a respective width in the X direction and a respective thickness in the Y direction. It will be further understood that although widths and thicknesses of each of the layers are shown, the relative widths and thicknesses of the layers are not necessarily to scale.

According to Figure 4A, a deposited flexible conductive shield layer 42A is formed on the substrate 41A and the combined first and second deposited flexible dielectric layer 43A is formed on the deposited flexible conductive shield layer 42A to fully surround the deposited flexible conductive layer 44A. A deposited flexible conductive shield layer 45A is formed on the combined first and second deposited flexible dielectric layer 43A in some embodiments according to the invention.

As shown in Figure 4A, the combined first and second deposited flexible dielectric layer 43A can have a width that is greater than a respective width of both the deposited flexible conductive shield layer 42A and the width of the deposited flexible conductive shield layer 45A in some embodiments according to the invention. In some embodiments according to the invention, any or all of the deposited flexible dielectric layers can include a piezoelectric material.

Figure 4B is a cross-sectional schematic illustrating a stacked structure 40B including a deposited flexible conductive layer 44B on a deposited flexible dielectric layer 43B and partially surrounded by a deposited flexible dielectric layer 43B in some embodiments according to the invention. According to Figure 4B, a deposited patterned flexible conductive shield 42B is deposited on the substrate 41B. According to Figure 4B, a deposited patterned flexible conductive shield 45B is deposited on the flexible dielectric 43B.

Figure 4C is a cross-sectional schematic illustrating a stacked structure 40C including a deposited flexible conductive layer 44C on a deposited flexible dielectric layer 43C and partially surrounded by a deposited flexible dielectric layer 43C in some embodiments according to the invention. According to Figure 4C, a deposited flexible conductive shield 42C is deposited on the substrate 41C. According to Figure 4C, a deposited patterned flexible conductive shield 45C is deposited on the flexible dielectric 43C.

Figure 4D is a cross-sectional schematic illustrating a stacked structure 40D including a deposited flexible conductive layer 44D into a dielectric layer 41D and partially surrounded by a deposited flexible dielectric layer 43D on the substrate 41D in some embodiments according to the invention. According to Figure 4D, a deposited patterned flexible conductive shield 42D is deposited on the flexible dielectric 43D. According to Figure 4D, a deposited patterned flexible conductive shield 45D is deposited on the flexible dielectric 46B.

Figure 4E is a cross-sectional schematic illustrating a stacked structure 40E including a deposited flexible conductive layer 44E into a dielectric layer 41E and partially surrounded by a deposited flexible dielectric layer 43E on the substrate 41E in some embodiments according to the invention. According to Figure 4E, a deposited flexible conductive shield 42E is deposited on the flexible dielectric 43E. According to Figure 4E, a deposited patterned flexible conductive shield 45E is deposited on the flexible dielectric 46E.

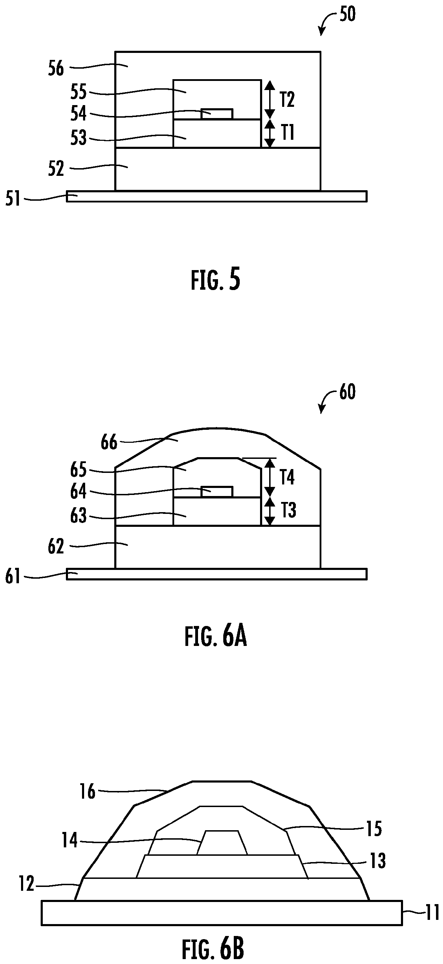

Figure 5 is a cross-sectional schematic illustrating a stacked structure 50 including a deposited flexible conductive layer 54 on a deposited flexible dielectric layer 53 and partially surrounded by a deposited flexible dielectric layer 55 in some embodiments according to the invention. According to Figure 5, a substrate 51 can be a rigid material, a flexible material such as a fabric, PET, paper, or the like and may include patterned conductive materials to be used in conjunction with the stacked structure 50 formed thereon. Each of the layers formed on the substrate 51 has a respective width in the X direction and a respective thickness in the Y direction. It will be further understood that although widths and thicknesses of each of the layers are shown, the relative widths and thicknesses of the layers are not necessarily to scale.

According to Figure 5, a deposited flexible conductive shield layer 52 is formed on the substrate 51 and the deposited flexible dielectric layer 53 is formed on the deposited flexible conductive shield layer 52. The deposited flexible conductive layer 54 is formed on the deposited flexible dielectric layer 53 and the deposited flexible dielectric layer 55 is formed on the deposited flexible dielectric layer 53 to partially surround the deposited flexible conductive layer 54. In particular, the deposited flexible dielectric layer 55 covers the side walls and upper surface of the deposited flexible conductive layer 54. A deposited flexible conductive shield layer 52 is formed to partially surround the deposited flexible conductive layer 54, the deposited flexible dielectric layer 53 and the deposited flexible dielectric layer 55.

As further shown in Figure 5, the deposited flexible dielectric layer 53 and the deposited flexible dielectric layer 55 can have respective thicknesses T1 and T2, which can be equal or different. Still further the deposited flexible dielectric layer 53 in the deposited flexible dielectric layer 55 can be made from different materials and therefore can have different dielectric constants to generate different electric fields associated with each in some embodiments according to the invention. In some embodiments according to the invention, any or all of the deposited flexible dielectric layers can include a piezoelectric material.

Figure 6A is a cross-sectional schematic illustrating a stacked structure 60 including a deposited flexible conductive layer 64 on a deposited flexible dielectric layer 63 and partially surrounded by a deposited flexible dielectric layer 65 thereon all of which is partially surrounded by a deposited flexible conductive shield layer 66 in some embodiments according to the invention. According to Figure 6A, a substrate 61 can be a rigid material, a flexible material such as a fabric, PET, paper, a vacu-form film or the like and may include patterned conductive materials to be used in conjunction with the stacked structure 60 formed thereon. Each of the layers formed on the substrate 61 has a respective width in the X direction and a respective thickness in the Y direction. It will be further understood that although widths and thicknesses of each of the layers are shown, the relative widths and thicknesses of the layers are not necessarily to scale.

According to Figure 6A, a deposited flexible conductive shield layer 62 is formed on the substrate 61 and the deposited flexible dielectric layer 63 is formed on the deposited flexible conductive shield layer 62. The deposited flexible conductive layer 64 is formed on the deposited flexible dielectric layer 63 and the deposited flexible dielectric layer 65 is formed thereon to partially surround the deposited flexible conductive layer 64. In particular, the deposited flexible dielectric layer 65 covers the side walls and upper surface of the deposited flexible conductive layer 64 and a deposited flexible conductive shield layer 66 is formed to partially surround the deposited flexible conductive layer 64, the deposited flexible dielectric layer 63 and the deposited flexible dielectric layer 65.

As further shown in Figure 6A, the deposited flexible dielectric layer 63 and the deposited flexible dielectric layer 65 can have respective thicknesses T3 and T4, which can be equal or different. Further, the deposited flexible dielectric layer 63 and the deposited flexible dielectric layer 65 can be made from different dielectric materials so that, in conjunction with the respective thicknesses, each of the materials can produce a different electric field in some embodiments according to the invention. As further shown, the upper surfaces of the deposited flexible dielectric layer 65 and the upper surfaces of the deposited flexible conductive shield layer 66 can be faceted or otherwise may be sloped relative to a central portion of the respective upper surface. In some embodiments according to the invention, any or all of the deposited flexible dielectric layers can include a piezoelectric material.

Accordingly, as appreciated by the present inventor, the electric fields generated in the dielectric layers can be tuned by selection of the dielectric constants or the piezoelectric response for the materials associated with each of the dielectric layers and by controlling the relative proportions of the dimensions of the dielectric layers (such as the thicknesses T1, T2, T3 and T4) and by causing the stacked structure to bend in a particular direction thereby concentrating the electric field in the particular direction. The facets can also allow the electric field generated by the deposited flexible dielectric layers to be directed in a specified direction to further improve the signal integrity of data transmitted. Further, as appreciated by the present inventor, concentrating the electric field in a particular direction (such as away from the body of a wearer) can reduce electromagnetic interference from external sources.

Figure 6B is a cross-sectional schematic illustrating a stacked structure having an alternative geometry to that shown in Figure 6A including a deposited flexible conductive layer on a first deposited flexible dielectric layer and partially surrounded by a second deposited flexible dielectric layer thereon all of which is partially surrounded by a deposited flexible conductive shield layer in some embodiments according to the invention. In particular the layers shown in Figure 6B can have tapered side walls and increased faceted upper surfaces to further bend in a particular direction thereby concentrating the electric field in the particular direction. The increased facets can also allow the electric field generated by the deposited flexible dielectric layers to be directed in a specified direction to further improve the signal integrity of data transmitted.

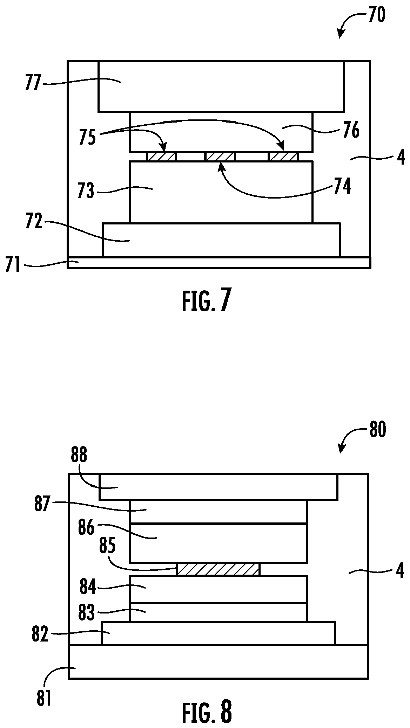

Figure 7 is a cross-sectional schematic illustrating a stacked structure 70 including a deposited flexible conductive layer 74 that can be located between a pair of deposited flexible dielectric layers 75 on a first deposited flexible dielectric layer 73 in some embodiments according to the invention. According to Figure 7, a substrate 71 can be a rigid material, a flexible material such as a fabric, PET, paper, or the like and may include patterned conductive materials to be used in conjunction with the stacked structure 70 formed thereon. Each of the layers formed on the substrate 71 has a respective width in the X direction and a respective thickness in the Y direction. It will be further understood that although widths and thicknesses of each of the layers are shown, the relative widths and thicknesses of the layers are not necessarily to scale.

According to Figure 7, a deposited flexible conductive shield layer 72 is formed on the substrate 71 and the deposited flexible dielectric layer 73 is formed on the deposited flexible conductive shield layer 72. The deposited flexible conductive layer 74 is formed on the deposited flexible dielectric layer 73. The pair of deposited flexible dielectric layers 75 can be formed on the deposited flexible dielectric layer 73 on both sides of the deposited flexible conductive layer 74 so that the deposited flexible dielectric layers in the pair 75 are directly adjacent to the deposited flexible conductive layer 74. In some embodiments according to the invention, the dielectric constants of the pair of deposited flexible dielectric layers 75 and the deposited flexible dielectric layers 73 and 76 can be selected to be different from one another. In some embodiments according to the invention, any or all of the deposited flexible dielectric layers can include a piezoelectric material.

Accordingly, as appreciated by the present inventor, the pair of deposited flexible dielectric layers 75 directly adjacent to the deposited flexible conductive layer 74 and the deposited flexible dielectric layers 73 and 76 can help protect the data signal from interference during transmission in some embodiments according to the invention.

Figure 8 is a cross-sectional schematic illustrating a stacked structure 80 including a deposited flexible conductive layer 85 on a series of deposited flexible dielectric layers 83 and 84 and having a series of deposited flexible dielectric layers 86 and 87 thereon having different dielectric constants in some embodiments according to the invention. According to Figure 8, a substrate 81 can be a rigid material, a flexible material such as a fabric, PET, paper, or the like and may include patterned conductive materials to be used in conjunction with the stacked structure 80 formed thereon. Each of the layers formed on the substrate 81 has a respective width in the X direction and a respective thickness in the Y direction. It will be further understood that although widths and thicknesses of each of the layers are shown, the relative widths and thicknesses of the layers are not necessarily to scale.

According to Figure 8, a deposited flexible conductive shield layer 82 is formed on the substrate 81. A deposited flexible dielectric layer 83 can be formed on the deposited flexible conductive shield layer 82 and a deposited flexible dielectric layer 84 can be formed on the deposited flexible dielectric layer 83.

A deposited flexible conductive layer 85 can be formed on the deposited flexible dielectric layer 84 and a deposited flexible dielectric layer 86 can be formed thereon. A deposited flexible dielectric layer 87 can be formed on the deposited flexible dielectric layer 86 and a deposited flexible conductive shield layer 88 can be formed thereon in some embodiments according to the invention.

In some embodiments according to the invention, the dielectric constants of the deposited flexible dielectric layers 83 and 84 can be different. In some embodiments according to the invention, the dielectric constants of the deposited flexible dielectric layers 83 and 84 can be different from the dielectric constants of the deposited flexible dielectric layers 86 and 87. In some embodiments according to the invention, any or all of the deposited flexible dielectric layers can include a piezoelectric material.

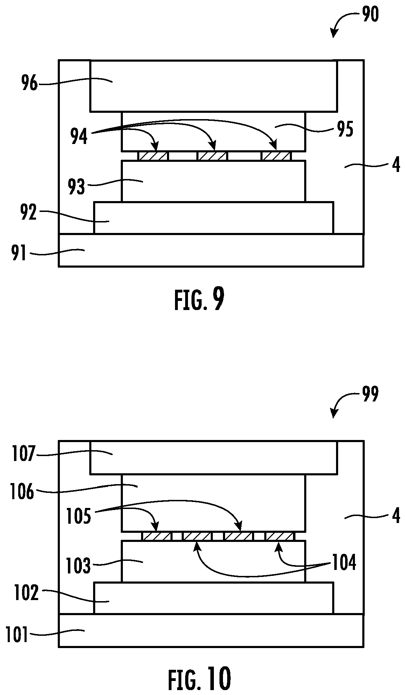

Figure 9 is a cross-sectional schematic illustrating a stacked structure including a series of deposited flexible conductive layers 94 spaced apart on a deposited flexible dielectric layer 93 and having a deposited flexible dielectric layer 95 thereon in some embodiments according to the invention. According to Figure 9, a substrate 91 can be a rigid material, a flexible material such as a fabric, PET, paper, or the like and may include patterned conductive materials to be used in conjunction with the stacked structure 90 formed thereon. Each of the layers formed on the substrate 91 has a respective width in the X direction and a respective thickness in the Y direction. It will be further understood that although widths and thicknesses of each of the layers are shown, the relative widths and thicknesses of the layers are not necessarily to scale.

According to Figure 9, a deposited conductive shield layer 92 is deposited on the substrate 91. The deposited flexible dielectric layer 93 is deposited on the deposited conductive shield layer 92. The series of deposited flexible conductive layers 94 are formed spaced apart on the deposited flexible dielectric layer 93 and the deposited flexible dielectric layer 95 is formed thereon in some embodiments according to the invention. A deposited flexible conductive shield layer 96 is formed on the deposited flexible dielectric layer 95. In some embodiments according to the invention, any or all of the deposited flexible dielectric layers 93 and 94 can include a piezoelectric material.

Figure 10 is a cross-sectional schematic illustrating a stacked structure 99 including a series of deposited flexible conductive layers spaced apart on a deposited flexible dielectric layer 103 where some of the conductive layers 104 are designated as signal carriers and others of the conductive layers 105 are designated as voltage reference (e.g., ground) carriers in some embodiments according to the invention. According to Figure 10, a substrate 101 can be a rigid material, a flexible material such as a fabric, PET, paper, or the like and may include patterned conductive materials to be used in conjunction with the stacked structure 99 formed thereon. Each of the layers formed on the substrate 101 has a respective width in the X direction and a respective thickness in the Y direction. It will be further understood that although widths and thicknesses of each of the layers are shown, the relative widths and thicknesses of the layers are not necessarily to scale.

According to Figure 10, a deposited flexible conductive shield layer 102 is deposited on the substrate 101 and the deposited flexible dielectric layer 103 is deposited thereon. In some embodiments according to the invention, the plurality of deposited flexible conductive layers 105 are formed on the deposited flexible dielectric layer 103. A first group of the deposited flexible conductive layers 105 can be configured to be signal carriers whereas a second group of the deposited flexible conductive layers 104 can be configured to be reference voltage-carriers in some embodiments according to the invention. In some embodiments according to the invention, the deposited flexible conductive layers 104 can be configured to be ground carriers. In some embodiments according to the invention, any or all of the deposited flexible dielectric layers can include a piezoelectric material.

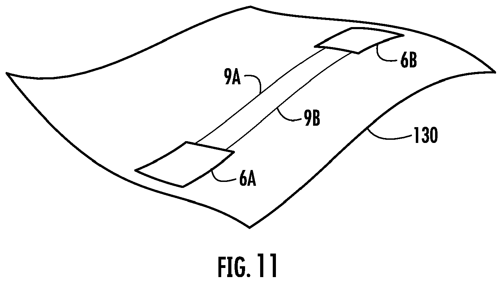

Figure 11 is a schematic illustration of a fabric 130 having first and second electronic devices 6A and 6B mounted thereon and electrically coupled to one another by a pair of transmission paths 9A and 9B extending therebetween in some embodiments according to the invention. As described above, it will be understood that the transmission paths 9A and 9B can be provided by the stacked structures and other structures described herein. According to Figure 11, any of these stacked structures described herein in reference to, for example, Figures 2-10 and 12-22 can be used to provide the transmission paths 9A and 9B to allow for improved signal or power integrity when carrying out data transfers.

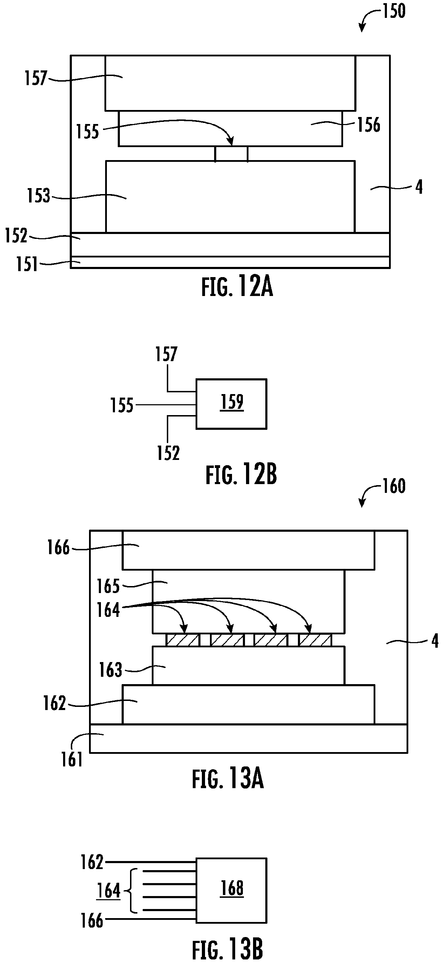

Figure 12A is a cross-sectional schematic illustrating a stacked structure 150 can include a substrate 151 having a deposited flexible conductive shield layer 152 formed thereon. A deposited flexible dielectric layer 153 can be formed on the deposited flexible conductive shield layer 152 and a deposited flexible conductive layer 155 can be formed thereon. A deposited flexible dielectric layer 156 can be formed on the deposited flexible conductive layer 155 and a deposited flexible conductive shield layer 157 can be formed on the deposited flexible dielectric layer 156 in some embodiments according to the invention. As shown in Figure 12B, the flexible conductive layer 155 and the deposited flexible conductive shield layer 152 and the deposited flexible conductive shield layer 157 can each be connected to a device 159 to provide the stacked structure 150 as the transmission path 9.

According to Figure 12A, the substrate 151 can be a rigid material, a flexible material such as a fabric, PET, paper, or the like and may include patterned conductive materials to be used in conjunction with the stacked structure 150 formed thereon. Each of the layers formed on the substrate 151 has a respective width in the X direction and a respective thickness in the Y direction. It will be further understood that although widths and thicknesses of each of the layers are shown, the relative widths and thicknesses of the layers are not necessarily to scale.

Figure 13A is a cross-sectional schematic illustrating a stacked structure 160 that can include a substrate 161 with a deposited flexible conductive shield layer 162 formed with a deposited flexible dielectric layer 163 thereon. A plurality of deposited flexible conductive layers 164 can be formed on the deposited flexible dielectric layer 163. A deposited flexible dielectric layer 165 can be formed on the plurality of deposited flexible conductive layers 164 and a deposited flexible conductive shield layer 166 can be formed thereon in some embodiments according to the invention.

Accordingly, the stacked structure 160 can carry multiple data or power signals concurrently to the device 168 while also providing improved transmission reliability. According to Figure 13A, the substrate 161 can be a rigid material, a flexible material such as a fabric, PET, paper, or the like and may include patterned conductive materials to be used in conjunction with the stacked structure 160 formed thereon. Each of the layers formed on the substrate 101 has a respective width in the X direction and a respective thickness in the Y direction. It will be further understood that although widths and thicknesses of each of the layers are shown, the relative widths and thicknesses of the layers are not necessarily to scale.

Figure 13B is a schematic illustrating the stacked structure 160 of Figure 13A having the plurality of conductive layers 164 and the conductive shield layers 162 and 166 coupled to an electronic device 168 in some embodiments according to the invention.

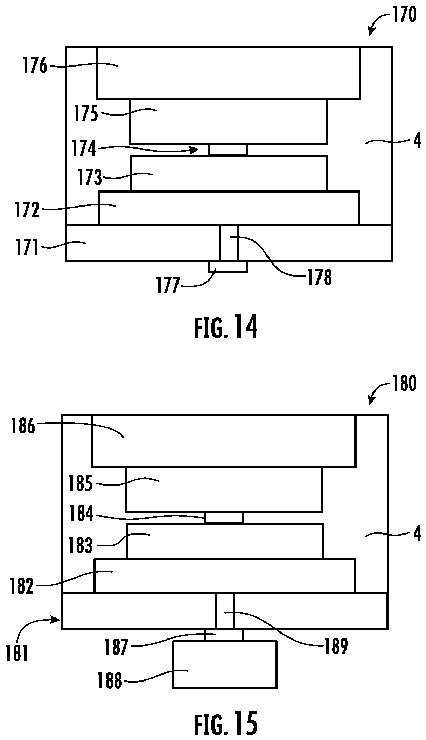

Figure 14 is a cross-sectional schematic illustrating a stacked structure 170 including a substrate 171 with a through-connect 178 therein and a deposited conductive layer 177 positioned beneath the through-connect 178 opposite a deposited flexible conductive shield layer 172 in some embodiments according to the invention. According to Figure 14, the substrate 171 can be a rigid material, a flexible material such as a fabric, PET, paper, Vacu-form film, or the like and may include patterned conductive materials to be used in conjunction with the stacked structure 170 formed thereon. Each of the layers formed on the substrate 171 has a respective width in the X direction and a respective thickness in the Y direction. It will be further understood that although widths and thicknesses of each of the layers are shown, the relative widths and thicknesses of the layers are not necessarily to scale.

Referring to Figure 14, in some embodiments according to the invention the deposited flexible conductive shield layer 172 is formed on the substrate 171 and a deposited flexible dielectric layer 173 can be formed thereon. A deposited flexible conductive layer 174 is formed on the deposited flexible dielectric layer 173 and a deposited flexible dielectric layer 175 is formed on the deposited flexible conductor layer 174. A deposited flexible conductive shield layer 176 is formed on the deposited flexible dielectric layer 175. In some embodiments according to the invention, the through-connect 178 can have a portion of the deposited flexible conductive layer 177 or 172 formed therein.

Figure 15 is a cross-sectional schematic illustrating a stacked structure 180 including a substrate 181 with a through-connect 189 therein and a deposited conductive layer 187 positioned beneath the through-connect 189 opposite a deposited flexible conductive shield layer 182. In some embodiments according to the invention, the deposited flexible conductive shield layer 182 is formed on the substrate 181 and a deposited flexible dielectric layer 183 can be formed thereon. A deposited flexible conductive layer 184 is formed on the deposited flexible dielectric layer 183 and a deposited flexible dielectric layer 185 is formed on the deposited flexible conductor layer 184. A deposited flexible conductive shield layer 186 is formed on the deposited flexible dielectric layer 185. A deposited flexible dielectric layer 188 can be formed beneath the deposited flexible conductor layer 187 opposite the through-connect 178 in the substrate 181 in some embodiments according to the invention. In some embodiments according to the invention, the through-connect 189 can have a portion of the deposited flexible conductive layer 187 formed therein.

According to Figure 15, the substrate 181 can be a rigid material, a flexible material such as a fabric, PET, paper, or the like and may include patterned conductive materials to be used in conjunction with the stacked structure 180 formed thereon. Each of the layers formed on the substrate 181 has a respective width in the X direction and a respective thickness in the Y direction. It will be further understood that although widths and thicknesses of each of the layers are shown, the relative widths and thicknesses of the layers are not necessarily to scale.

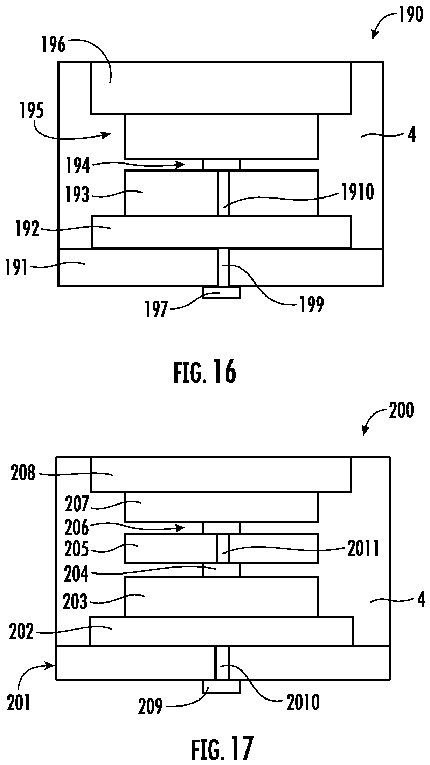

Figure 16 is a cross-sectional schematic illustrating a stacked structure 190 including a substrate 191 with a through-connect 199 therein and a deposited conductive layer 197 positioned beneath the through-connect 199 opposite a deposited flexible conductive shield layer 192. The deposited flexible conductive shield layer 192 is formed on the substrate 191. A deposited flexible dielectric layer 193 can be formed thereon with an opening 1910 therein. A deposited flexible conductive layer 194 is formed on the deposited flexible dielectric layer 193 over the opening 1910 and a deposited flexible dielectric layer 195 is formed on the deposited flexible conductor layer 194. A deposited flexible conductive shield layer 196 is formed on the deposited flexible dielectric layer 195. In some embodiments according to the invention, the throughconnects 199 and 1910 can have a portion of the deposited flexible conductive layers 197 and 194, respectively, formed therein.

According to Figure 16, the substrate 191 can be a rigid material, a flexible material such as a fabric, PET, paper, or the like and may include patterned conductive materials to be used in conjunction with the stacked structure 190 formed thereon. Each of the layers formed on the substrate 191 has a respective width in the X direction and a respective thickness in the Y direction. It will be further understood that although widths and thicknesses of each of the layers are shown, the relative widths and thicknesses of the layers are not necessarily to scale.

Figure 17 is a cross-sectional schematic illustrating a stacked structure 200 including a substrate 201 with a through-connect 2010 therein and a deposited conductive layer 209 positioned beneath the through-connect 2010 opposite a deposited flexible conductive shield layer 202. The deposited flexible conductive shield layer 202 is formed on the substrate 201 and a deposited flexible dielectric layer 203 can be formed thereon. A deposited flexible conductive layer 204 is formed on the deposited flexible dielectric layer 203 and a deposited flexible dielectric layer 205 is formed with an opening 2011 therein above the deposited flexible conductor layer 204. A deposited flexible conductor layer 206 deposited over the opening 2011 and a deposited flexible dielectric layer 207 is formed thereon. A deposited flexible conductive shield layer 208 can be formed on the deposited flexible dielectric layer 207. In some embodiments according to the invention, the openings 2010 and 2011 can have portions of the deposited flexible conductive layers 209 and 204 and/or 206, respectively, formed therein.

According to Figure 17, the substrate 201 can be a rigid material, a flexible material such as a fabric, PET, paper, or the like and may include patterned conductive materials to be used in conjunction with the stacked structure 200 formed thereon. Each of the layers formed on the substrate 201 has a respective width in the X direction and a respective thickness in the Y direction. It will be further understood that although widths and thicknesses of each of the layers are shown, the relative widths and thicknesses of the layers are not necessarily to scale.

Figure 18A is a schematic illustration of the garment 8 including one or more conductive threads woven with a plurality of dielectric threads. According to Figure 18A, the conductive thread 241 is woven into the garment 8 by alternatingly passing over opposing upper and lower surfaces of directly adjacent ones of the dielectric threads. For example, conductive thread 241 passes beneath the dielectric thread 50 on the lower surface of the garment 8 and then passes over the directly adjacent dielectric thread 51 on the upper surface of the garment 8 as shown in greater detail in Figure 18B.

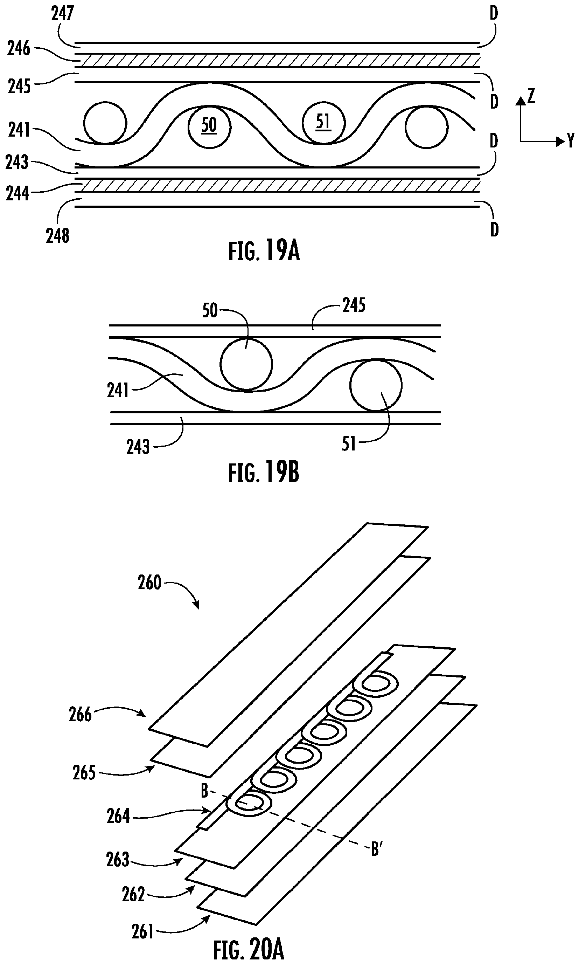

Figure 18C is an illustration of a knitted fabric including one or more conductive threads integrated therein with a plurality of dielectric threads, which can be utilized in the arrangements shown in Figure 19A and 19B in some embodiments according to the present invention.

Figure 18D is an illustration of a fabric including one or more non-woven conductive threads integrated therein with a woven inlay of plurality of dielectric threads, which can be utilized in the arrangements shown in Figure 19A and 19B in some embodiments according to the present invention.

Figure 19A is a cross-sectional schematic illustrating the woven conductive and dielectric threads shown in Figures 18A and 18B having deposited flexible dielectric layers and deposited flexible conductive shield layers coupled to the opposing sides of the garment 8 in some embodiments according to the invention. According to Figure 19A, a series of layers can be deposited onto each of the opposing surfaces of the garment 8 in some embodiments according to the present invention. For example, a deposited flexible dielectric layer 245 can be formed on the upper surface of the garment 8, a deposited flexible conductive shield layer 246 can be formed on the deposited flexible dielectric layer 245, and a deposited flexible dielectric layer 246 can be formed on the deposited flexible conductive shield layer 246.

Furthermore, a deposited flexible dielectric layer 243 can be formed on the lower surface of the garment 8, a deposited flexible conductive shield layer 244 can be formed on the deposited flexible dielectric layer 243, and a deposited flexible dielectric layer 248 can be formed on the deposited flexible conductive shield layer 244 in some embodiments according to the invention.

In some embodiments according to the invention, the layers included in the series of layers can be formed on the surfaces of the garment 8 in-situ. In some embodiments according to the invention, the layers included in the series of layers can be formed on a substrate which is coupled to the surfaces of the garment 8. In some embodiments according to the invention, the series of layers described above may be formed on the upper surface or on the lower surface of the garment.

Figure 19B is a cross-sectional schematic illustrating the woven conductive and dielectric threads shown in Figures 18A and 18B having deposited flexible dielectric layers coupled to opposing sides of the fabric in some embodiments according to the invention. In some embodiments according to the invention, a deposited flexible dielectric layer 245 can be formed on the upper surface of the garment 8 and a deposited flexible dielectric layer 243 can be formed on the lower surface of the garment 8. In some embodiments according to the invention, the deposited flexible dielectric layers can be formed on the surfaces of the garment 8 in-situ. In some embodiments according to the invention, the deposited flexible dielectric layers can be formed on a substrate which is coupled to the surfaces of the garment 8. In some embodiments according to the invention, the deposited flexible dielectric layers described above may be formed on the upper surface or on the lower surface of the garment. In some embodiments according to the invention, the deposited flexible dielectric layers can have a thickness in a range between about .005 mm to about 4 mm.

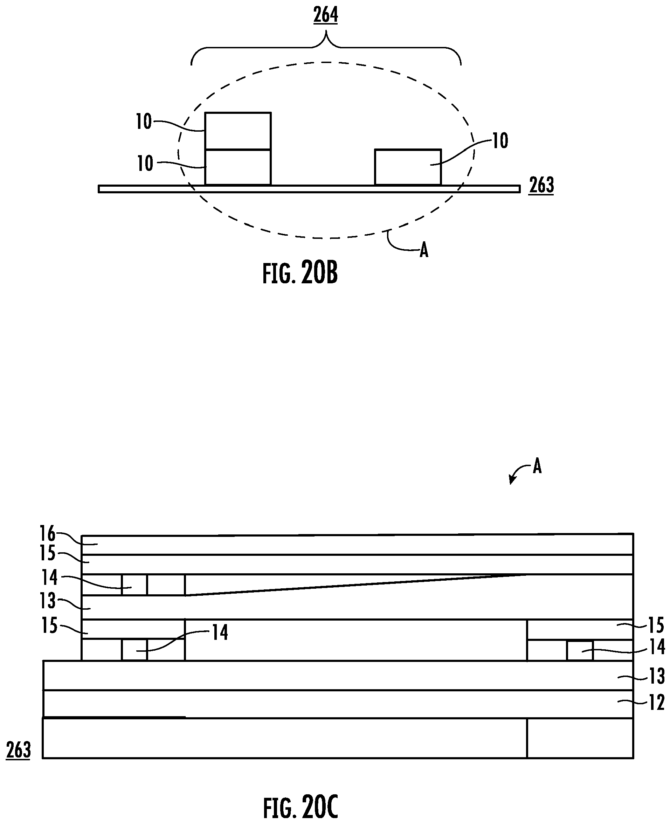

Figure 20A is a perspective schematic illustrating a looped stacked structure 260 extending on a substrate 263 to form inductive elements in some embodiments according to the invention. Figure 20B is a cross-sectional schematic illustrating the looped stacked structure 260 shown in Figure 20A in some embodiments according to the invention. Figure 20C is a cross-sectional schematic illustrating a detailed view of the looped stacked structure 260 shown in Figure 20B including where the layers included in the stacked structures 10 overlap one another in some embodiments according to the invention.

According to Figures 20A-20C, the stacked structure 10 including the layers described herein in reference to Figure 2A, extends on the substrate 263 along a path that includes a series of loops that result in first portions of the stacked structure 10 overlapping section portions of the stacked structure 10. As shown in Figure 20C, the second portions of the stacked structure 10 are at a first level relative to the substate 26 whereas the first portions of the stacked structure 10 are at a second level relative to the substate 26 and are overlying the second portions of the stacked structure 10.

In some embodiments according to the invention, the looped stacked structure 260 can be formed by forming the second portion of the stacked structure 10 (the first level) to extend on the substrate 263 along the path defining the series of loops thereby forming the first portion of the stacked structure 10 by crossing over the second portion of the stacked structure. It will be understood that although the present embodiment refers to the layers include in the stacked structure 10 in Figure 2A, the stacked structure of any embodiment described herein may be used to form the looped stacked structure 260.

In some embodiments according to the invention, a deposited flexible conductive shield layer 262 can be formed on a substrate 261 and a deposited flexible dielectric layer 263 can be formed on the deposited flexible conductive shield layer 262. The looped structure 264 can be formed on deposited flexible dielectric layer 263 and a deposited flexible dielectric layer 265 can be formed over the looped structure 264 and the deposited flexible dielectric layer 263. A deposited flexible conductive shield layer 266 can be formed on the deposited flexible dielectric layer 265. In some embodiments according to the invention, a dielectric ink can be deposited on the deposited flexible dielectric layer 263 inside the loops of the looped structure 264.

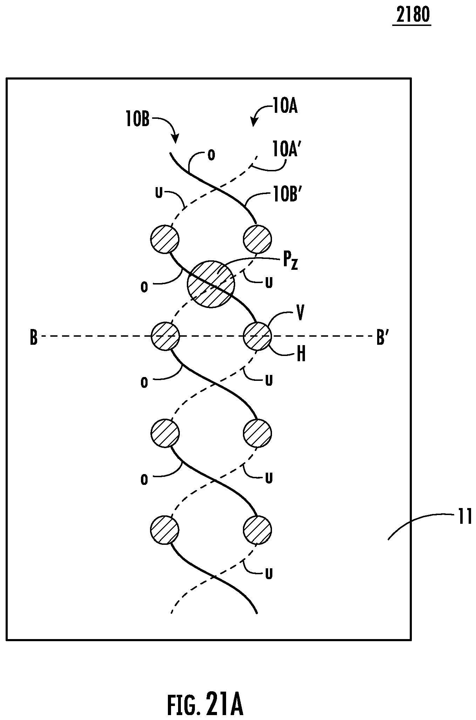

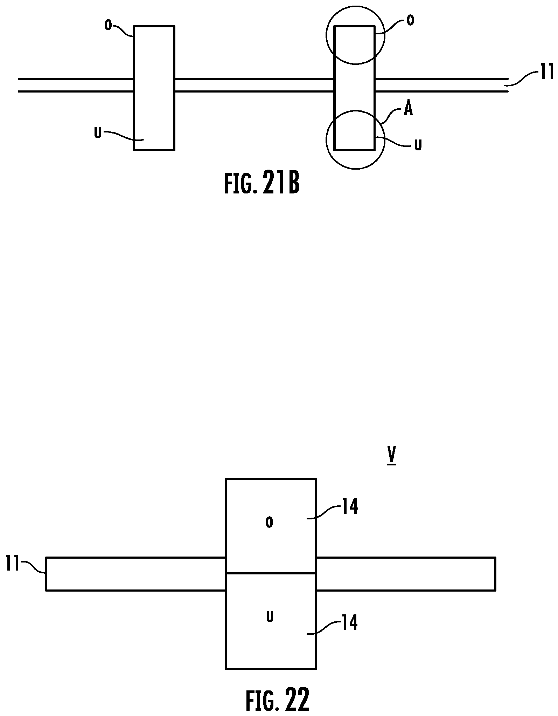

Figure 21A is a schematic plan view of a twisted pair structure 2100 including serpentine patterns 10A and 10B each including a plurality of first and second deposited flexible conductive segments O and U on opposing surfaces of a deposited flexible dielectric substrate 11 to cross over one another in some embodiments according to the invention. Figure 21B is a cross-sectional schematic illustrating the structure shown in Figure 21A taken along line 21B-21B' in some embodiments according to the invention. Figure 22 is a detailed cross-sectional schematic illustrating the regions O and U shown in Figure 21B in some embodiments according to the invention.

According to Figures 21A, 21B, and 22, each of the serpentine patterns 10A and 10B forms a respective deposited flexible conductive layer. Each of the respective deposited flexible conductive layer can include a plurality of first segments O that are on an upper surface of the substrate 11 and a plurality of second segments U that are on a lower surface of the substrate 11. Each of the serpentine patterns 10A and 10B can also include vias V where the segments on the upper surface meet the segments on the lower surface to electrically couple the segments together. As shown in Figure 22, the segment O in the upper portion of the via V contacts the segment U in the lower portion of the via V to that each of the segments (U and O) can be electrically coupled together to form the twisted pair structure 2100 in some embodiments according to the present invention. In some embodiments according to the invention, the substrate can refer to a deposited dielectric layer. In some embodiments according to the invention, Pz is a deposited dielectric layer between segment O and segment U.

Figure 23 is a schematic illustrating a housing structure 251 in an upside-down configuration that provides a recess 220 configured to secure a packaged integrated circuit device 250 inserted through a bottom opening into the recess 220 of the housing structure 251 in some embodiments according to the invention. Figure 24 is a schematic illustrating the housing structure 251 in a right side up configuration that provides the recess 220 configured to secure the packaged integrated circuit device 250 inserted through a top opening into the recess 220 in some embodiments according to the invention.

Referring to Figures 23 and 24, the side wall 210 extends around a perimeter of the housing structure 251 to define an interior region thereof providing the recess 220 configured to hold the packaged integrated circuit device 250 inserted through the opening at the bottom of the housing structure 251. The perimeter of the housing structure 251 also defines an exterior region that is outside the interior region.

As further shown in Figure 23, a plurality of pads 215 are positioned in the side wall 210 of the housing structure 251 to align with leads 216 of the packaged integrated circuit device 250 so that when the packaged integrated circuit device 250 is inserted into the housing structure 251, the leads 216 of the packaged integrated circuit device 250 will come into contact with the corresponding ones of the pads 215 so that data and other signals provided to the housing structure 251 via, for example the stacked structures 10 or the flexible electrical conductors shown in Figures 18A-19B, can be electrically coupled to circuits inside the packaged integrated circuit device 250.

As further shown in Figures 23 and 24, the housing structure 251 can include a flange 254 that is coupled to the side wall 210 by a hinge portion 257 of the flange 254. In some embodiments according to the invention, the hinge portion 257 of the flange 254 is pliable to allow the flange 254 to move when the housing structure 251 is coupled to, for example, the garment 8. As appreciated by the present inventor, the flange 254 can allow the housing structure 251 to be coupled to the garment 8 while also allowing for movement of the garment 8. In some embodiments the hinge portion 257 of the flange 254 is configured to cantilever the flange 254 over the exterior region of the housing structure 251. In some embodiments according to the present invention, the flange 254 can include a tail portion 261 that is configured to rest adjacent to a surface on which the housing structure 251 is to be mounted, such as the garment 8. In some embodiments according to the invention, the flange 254 can have a flared profile that extends outward from the side wall 210 at the hinge portion 257 and flattens adjacent to the tail portion 261 of the flange 2.

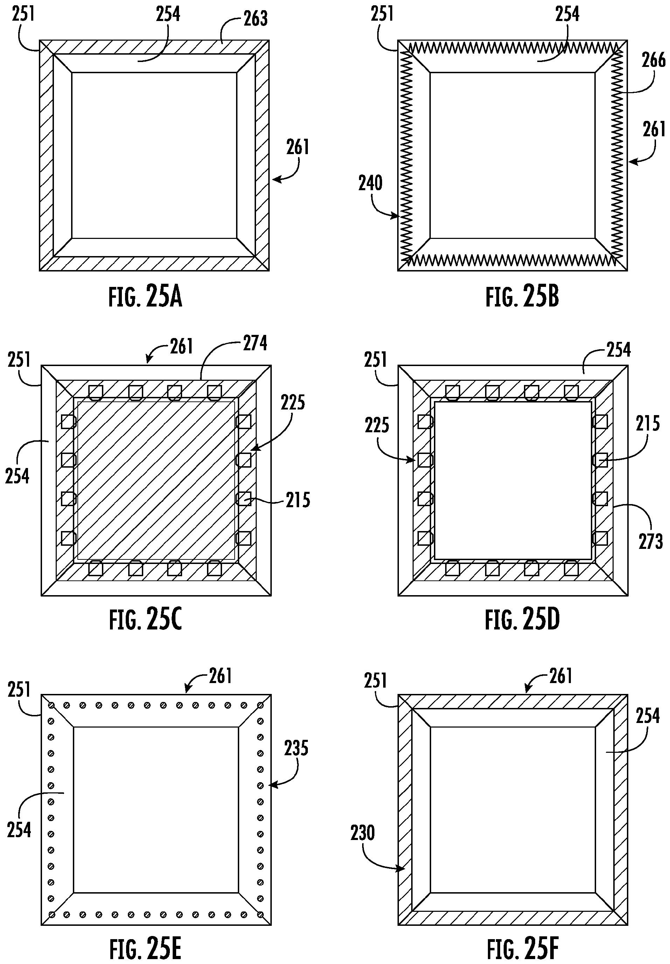

In some embodiments according to the invention, the hinge portion 257 can be a compliant mechanism that provides at least one compliant degree of freedom to allow the flange 254 to move between various positions including but not limited to a relaxed position where tail 261 of the flange 254 is not secured to the substrate and to mounted position where the tail 261 of the flange 254 is secured to the substrate by, for example the features described herein with refence to Figures 25A-25F. Other techniques can be used to secure the tail 261 of the flange 254 to the substrate. In some cases, the at least one compliant degree of freedom includes only one compliant degree of freedom. In some cases, the at least one compliant degree of freedom includes more than one compliant degree of freedom, such as two, three, four, or more compliant degrees of freedom.

In some embodiments according to the invention, the hinge portion 257 includes a living hinge comprising a unitary material structure of the housing structure 251 that is configured to impart a force on the flange 254 to move the tail 261 towards the substrate resulting from elastic body deformation of the living hinge in some embodiments according to the invention. In some embodiments of the invention, a woven or non-woven textile can be embedded in the hinge portion 257 or flange 254.

In some embodiments according to the invention, the living hinge can include a thinned portion have a vertical thickness that may be thinner than a vertical thickness of adjoining portions of the hinge portion 257. In some embodiments according to the invention, the living hinge can be made of polypropylene.

In some embodiments according to the invention, the tail 261 can be biased by the hinge portion 257 away from the surface of the garment 8 to form a gap therebetween until the tail 261 is secured to the garment 8 using, for example, the features described in reference to Figure 25A-25F. In some embodiments according to the invention, the tail 261 can be biased by the hinge portion 257 toward the surface of the garment 8.

In some embodiments according to the invention, the flange 254 can include a base portion 264 that extends along an underside of the flange 254 from the tail portion 261 back toward the side wall 210. In some embodiments according to the invention, the base portion 264 couples to the side wall 210. In some embodiments according to the invention, the base portion 264 is separated from the side wall 210 so that the base portion 264 of the flange 254 is at least partially open. In some embodiments according to the invention, the base portion 264 can be absent from the flange 254. In some embodiments according to the invention, the housing structure 251 can be formed of Injection-molded HDPE, 3D printed TPU (ninjaflex), Formlabs silicone resin, molded silicone, molded urethane, and the like.

Figures 25A is a plan view of the housing structure 251 including the tail portion 261 of flange 254 including an adhesive film 263 in some embodiments according to the invention. According to Figure 25A, in some embodiments according to the invention, the adhesive film 263 can be configured to secure the housing structure 251 to the surface of, for example, the garment 8. In some embodiments according to the invention, the adhesive film 263 can be on the base portion 264 of the flange 254. In some embodiments according to the invention, the adhesive film 263 can be formed of DuPont Intexar TE series, or other temperature-dependent mechanical adhesive film.

Figure 25B is a plan view of the housing structure 251 including the tail portion 261 of flange 254 including a stitching area 266 in some embodiments according to the invention. According to Figure 25B, in some embodiments according to the invention, the stitching area 266 can be thicker than adjacent areas of the tail portion 261 to reinforce the flange 254 when stitched to the garment 8 to guard against the housing structure 251 tearing away from the garment 8 under stress. In some embodiments according to the invention, the stitching area 266 can include holes that allow for the housing structure 251 to be more easily sewn into the garment 8. In some embodiments according to the invention, the stitching area 266 can also be on the base portion 264 of the flange 254.

Figure 25C is a plan view of the housing structure 251 including an anisotropic conducting film 266 on the tail portion 261 of flange 254 and on a bottom of the housing structure 251 spanning the recess 220 in some embodiments according to the invention. According to Figure 25C, in some embodiments according to the invention, the anisotropic conducting film 266 can have a relatively high electrical conductivity in one direction more than other directions when heated to an activation temperature. When the anisotropic conducting film 266 is activated, the electrical signals can be effectively coupled from the transmission path 9 in the garment 8 to the leads of the packaged integrated circuit device 250 through the pads 215 of the housing structure 251. It will be understood, however, that the areas of the anisotropic conducting film 266 that are not in contact with conductors in the garment 8 or the pads 215, will not couple voltage to the housing structure 251 in some embodiments according to the invention. In some embodiments according to the invention, the anisotropic conducting film or adhesive 266 can be formed of Creative Materials 124-22C, 3M Anisotropic Conductive Film 5363, or the like.

Figure 25D is a plan view of the housing structure 251 including an anisotropic conducting film 266 on the tail portion 261 of flange 254 in some embodiments according to the invention. As further shown in Figure 25D, the anisotropic conducting film 266 is absent from the bottom of the housing structure 251 that spans the recess 220. According to Figure 25D, in some embodiments according to the invention, the anisotropic conducting film 266 can have a relatively high electrical conductivity in one direction more than other directions when heated to an activation temperature. When the anisotropic conducting film 266 is activated, the electrical signals can be effectively coupled from the transmission path 9 in the garment 8 to the leads of the packaged integrated circuit device 250 through the pads 215 of the housing structure 251. In some embodiments according to the invention, the anisotropic conducting film 266 can be formed of Creative Materials 124-22C, 3M Anisotropic Conductive Film 5363, or the like.

Figure 25E is a plan view of the housing structure 251 including the tail portion 261 of flange 254 including a rivet area 235 in some embodiments according to the invention. According to Figure 25E, in some embodiments according to the invention, the rivet area 235 can be thicker than adjacent areas of the tail portion 261 to reinforce the flange 254 when riveted to the garment 8 to guard against the housing structure 251 tearing away from the garment 8 under stress. In some embodiments according to the invention, the rivet area 235 can include holes configured to accept rivets that extend through the flange 254 to penetrate the garment 8. In some embodiments accord to the invention, the rivet area 235 may not include the holes. In such embodiments, the rivets can pierce the flange 2554 and penetrate the garment 8. In some embodiments according to the invention, rivets may be molded in with the flange and applied to fabric then riveted.

Figure 25F, is a plan view of the housing structure 251 including the tail portion 261 of flange 254 including a bonding area 254 in some embodiments according to the invention. According to Figure 25F, in some embodiments according to the invention, the bonding area 254 can be configured to bond to an underlying material at a bonding temperature to secure the housing structure 251 to the surface of, for example, the garment 8. In some embodiments according to the invention, the bonding area 254 bonds at a temperature greater than the activation temperature of the anisotropic conducting film 266 described in reference to Figures 25C and 25D. In some embodiments according to the invention, the bonding area 254 can be formed of Injection-molded HDPE, 3D printed TPU (ninjaflex), Formlabs silicone resin, molded silicone, molded urethane, a textile-embedded composite, and the like.

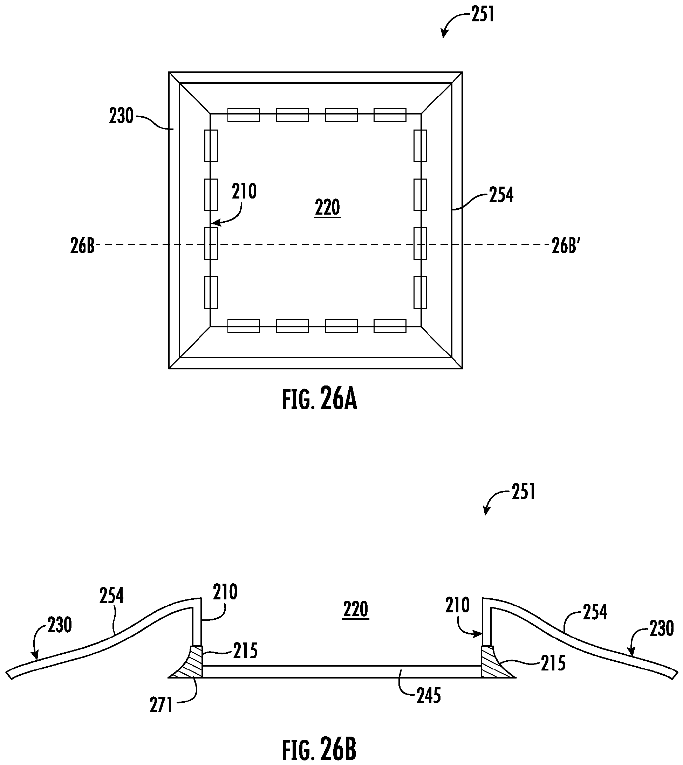

Figures 26A is a schematic plan view of a housing structure 251 illustrating the plurality of pads 315 and the side wall 210 of the flange 254 extending around the perimeter in some embodiments according to the invention. Figure 26 B is a cross-sectional schematic illustrating the portion of the housing structure 251 shown in Figure 26A taken along line B-B' in some embodiments according to the invention. Referring to Figures 26A-26B, in some embodiments according to the invention, the pads 215 can include a tapered base portion 271 that is configured to electrically contact, for example, the stacked structures configured to carry signals on or in the substrate to which the housing structure 251 is coupled. As shown, in some embodiments according to the invention, the lower part of the tapered base portion 271 can wider that upper portions of the pad 215. As further shown, in some embodiments according to the invention, the pads 215 can be a unitary structure that extends from the tapered base portion 271 though the side wall to contact a lead of a package integrated circuit device. In some embodiments according to the invention, the pads 215 can be a conducive material that forms part of the housing structure 251 at side wall 210 locations to contact, for example, the stacked structures configured to carry signals on or in the substrate to which the housing structure 251 is coupled.

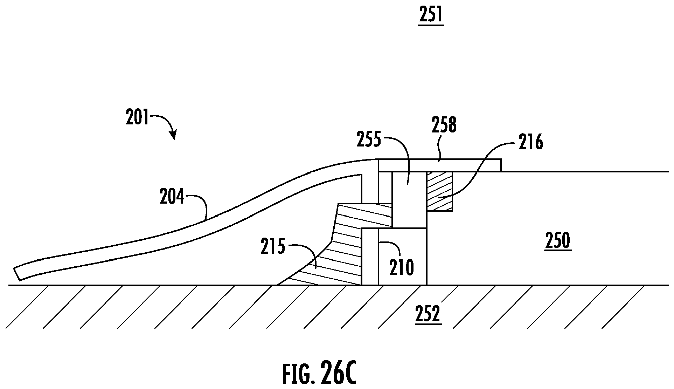

Figure 26C is a cross-sectional schematic illustrating a portion of the side wall 210 of the housing structure 251 where the pad 215 extends through the side wall 210 to contact components 255 mounted on a printed circuit board 258 coupled to the packaged integrated circuit device 250 secured in the recess 220 in some embodiments according to the invention. As shown in Figure 26C, in some embodiments according to the invention, the printed circuit board 258 can be located proximate to an upper edge of the side wall 210 when the housing structure 251 is in the upside-down configuration. In some embodiments according to the invention, the printed circuit board 258 can carry discrete and/or active electronic components. In some embodiments according to the invention, the printed circuit board 258 can carry a local charge storage device that can receive charge transferred via a signaling protocol. Other components and functions may be supported by devices on the printed circuit board 258.

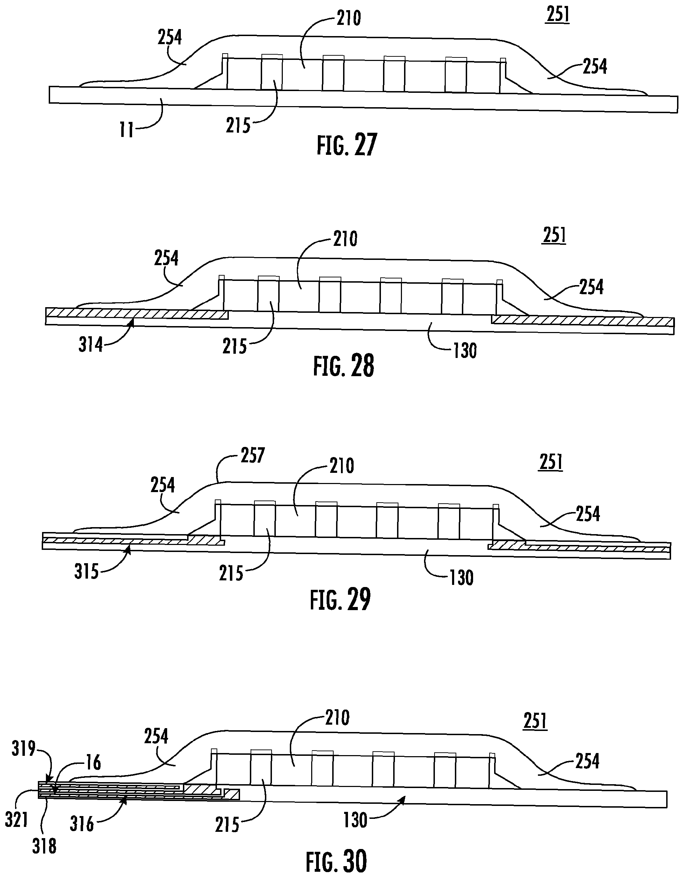

Figure 27 is a cross-sectional schematic illustrating the housing structure 251 mounted on a substrate 11 with the side wall 210 and the pads 215 visible through the flange 254 in some embodiments according to the invention. According to Figure 27, the housing structure 251 is shown with the tail portion 261 of the flange 254 coupled to the substrate 11 to provide contact between the pads 215 and the corresponding ones of the conductors on the substrate 11. As further shown in Figure 27, in some embodiments according to the invention, the pads 215 can be located in the side wall 210 below the level where the hinge portion 257 of the flange 254 meets the side wall 210.

Figure 28 is a cross-sectional schematic illustrating the housing structure 251 mounted on the surface of a dielectric fabric 130 having a conductor 314 thereon and the pads visible through the flange 254 in some embodiments according to the invention. As shown in Figure 28, the housing structure 251 is shown with the tail portion 261 of the flange 254 coupled to the dielectric fabric 130 to provide contact between the tapered base portion of the pad 215 and the conductor 314 on the dielectric fabric 130. In some embodiments according to the invention, the conductor 314 can be the stacked structure described herein. In some embodiments according to the invention, the conductor 314 can be a conductive thread having deposited flexible dielectric layers formed thereon as described herein. As further shown in Figure 28, in some embodiments according to the invention, the pads 215 can be located in the side wall 210 below the level where the hinge portion 257 of the flange 254 meets the side wall 210.

Figure 29 is a cross-sectional schematic illustrating the housing structure 251 mounted on the surface of the dielectric fabric 130 having a conductor 315 embedded therein and the pads visible through the flange 254 in some embodiments according to the invention. As shown in Figure 29, the housing structure 251 is shown with the tail portion 261 of the flange 254 coupled to the dielectric fabric 130 to provide contact between the tapered base portion of the pad 215 and the conductor 315 in the dielectric fabric 130. In some embodiments according to the invention, the conductor 315 can be the stacked structure as described herein. In some embodiments according to the invention, the conductor 315 can be a conductive thread having deposited flexible dielectric layers formed thereon as described herein. As further shown in Figure 29, in some embodiments according to the invention, the pads 215 can be located in the side wall 210 below the level where the hinge portion 257 of the flange 254 meets the side wall 210.

Figure 30 is a cross-sectional schematic illustrating the housing structure 251 mounted on the surface of the dielectric fabric 130 having a conductor 316 embedded therein and the pads visible through the flange 254 in some embodiments according to the invention. As shown in Figure 30, the housing structure 251 is shown with the tail portion 261 of the flange 254 coupled to the dielectric fabric 130 to provide contact between the tapered base portion of the pad 215 and the conductor 316 in the dielectric fabric 130. In some embodiments according to the invention, the conductor 316 can be the stacked structure including a deposited flexible conductive layer 321 and deposited flexible conductive shield layers 318 and 319 having portions of the dielectric fabric located between the layers as described herein. In some embodiments according to the invention, the conductor 316 can be a conductive thread having deposited flexible dielectric layers formed thereon as described herein. As further shown in Figure 30, in some embodiments according to the invention, the pads 215 can be located in the side wall 210 below the level where the hinge portion 257 of the flange 254 meets the side wall 210.

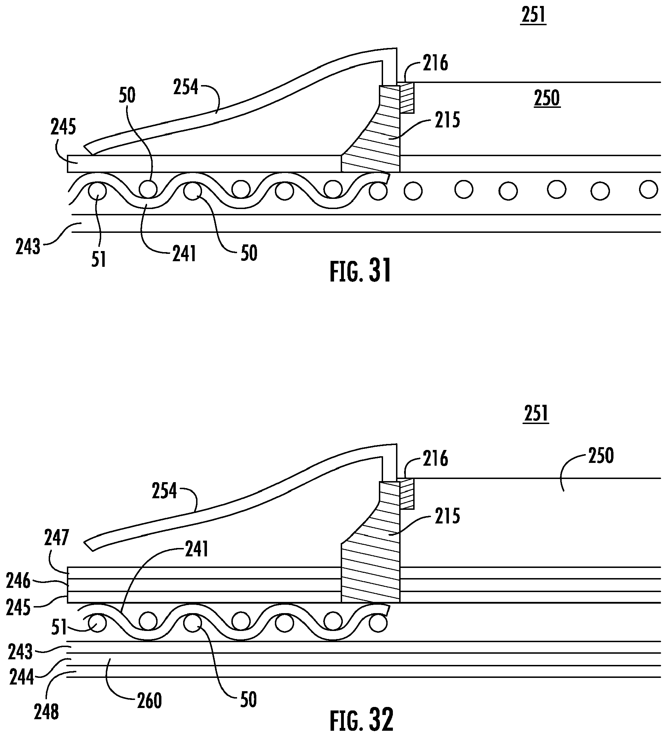

Figure 31 is a cross-sectional schematic illustrating the housing structure 251 coupled to a fabric including conductive threads 241 woven with dielectric threads 50 and 51 and having deposited flexible dielectric layers 245 and 243 coupled to the surfaces of the fabric in some embodiments according to the invention. As shown in Figure 31, the conductive thread 241 is woven to a location below the pad 215. In some embodiments according to the invention, the tapered portion of the pad 215 extends through the deposited flexible dielectric layer 245 to contact the conductive thread 241 so that the signal carried by the conductive thread 241 is coupled to the lead 216 of the packaged integrated circuit device 250 secured in the housing structure in some embodiments according to the invention. In some embodiments according to the invention, the tapered portion of the pad 215 can be comprised of a thermoplastic conductor, which melts down to couple with the conductive thread 241. In another embodiment, a metal can be mechanically pressed to make contact with the conductive thread 241. In another embodiment, the tapered portion of the pad 215 can be made of a wire that deforms to press against the conductive thread 251.

Figure 32 is a cross-sectional schematic illustrating the housing structure 251 coupled to a fabric including conductive threads 241 woven with dielectric threads 50 and 51 and having deposited flexible dielectric layers 245, 247, 243, and 248 and deposited flexible conductive shield layers 246 and 244 coupled to the upper and lower surfaces of the fabric in some embodiments according to the invention. As shown in Figure 31, the conductive thread 241 is woven to a location below the pad 215. In some embodiments according to the invention, the tapered portion of the pad 215 extends through the deposited flexible dielectric layers 247 and 245 and through the intervening deposited flexible conductive shield layers 246 to contact the conductive thread 241 so that the signal carried by the conductive thread 241 is coupled to the lead 216 of the packaged integrated circuit device 250 secured in the housing structure in some embodiments according to the invention.

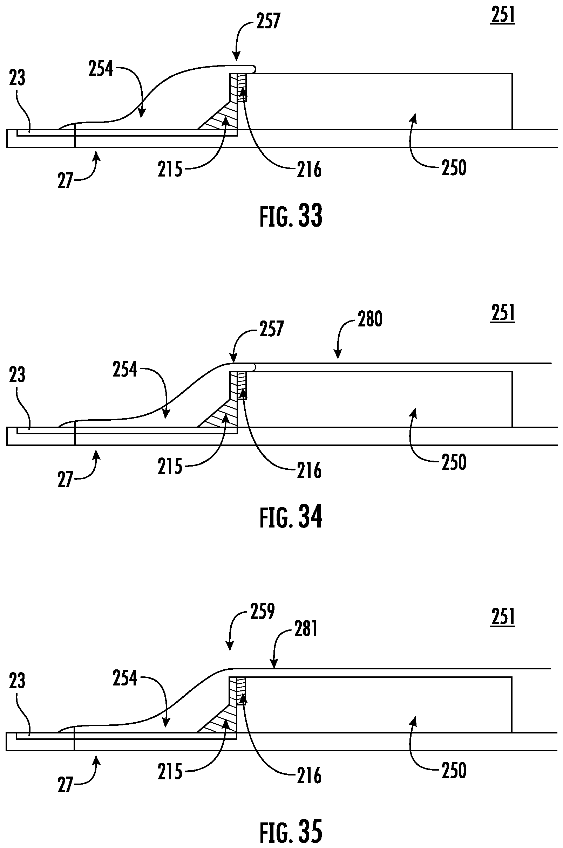

Figure 33 is a cross-sectional schematic illustrating the housing structure 251 mounted on a substrate 27 including the packaged integrated circuit device 250 secured in the recess in an upside-down orientation where the leads 216 of the packaged integrated circuit device 250 are positioned proximate to the hinge portion 257 of the flange 254 when inserted into the recess and the housing structure 251. In some embodiments according to the invention, the housing structure 251 is open at the top to expose the lower surface of the packaged integrated circuit device in some embodiments according to the invention.

As shown in Figure 33, a conductor 23 can be on a surface of the substrate 27 and extend under the flange 254 to contact the pad 215 which can couple the signal carried by the conductor 23 to the lead 216 of the packaged integrated circuit device 250 in some embodiments according to the invention. In some embodiments according to the invention, the conductor 23 can be any of the flexible electrical conductors described herein, such as a conductive thread in a woven fabric, a conductive thread in a knitted fabric, or a deposited flexible conductor layer. Other types of flexible electrical conductor may also be used. In some embodiments according to the invention, flange may be coupled to the substrate 27 by any of the structures shown, for example, in Figures 25A-25F.

Figure 34 is a cross-sectional schematic illustrating the housing structure 251 mounted on a substrate 27 including the packaged integrated circuit device 250 secured in the recess in an upside-down orientation where the leads 216 of the packaged integrated circuit device 250 are positioned proximate to the hinge portion of the flange 254 when inserted into the recess. In some embodiments according to the invention, the housing structure 251 is open at the top to expose a heat sink 280 attached to the lower surface of the packaged integrated circuit device 250 in some embodiments according to the invention.

As shown in Figure 34, a conductor 23 can be on the surface of the substrate 27 and extend under the flange 254 to contact the pad 215 which can couple the signal carried by the conductor 23 to the lead 216 of the packaged integrated circuit device 250 in some embodiments according to the invention. In some embodiments according to the invention, the conductor 23 can be any of the flexible electrical conductors described herein, such as a conductive thread in a woven fabric, a conductive thread in a knitted fabric, or a deposited flexible conductor layer. Other types of flexible electrical conductor may also be used. In some embodiments according to the invention, flange may be coupled to the substrate 27 by any of the structures shown, for example, in Figures 25A-25F.

Figure 35 is a cross-sectional schematic illustrating the housing structure 251 mounted on a substrate 27 including the packaged integrated circuit device 250 secured in the recess in an upside-down orientation where the leads 216 of the packaged integrated circuit device 250 are positioned proximate to the hinge portion 257 of the flange 254 when inserted into the recess. In some embodiments according to the invention, the housing structure 251 is closed at the top to cover the lower surface of the packaged integrated circuit device 250 in some embodiments according to the invention.

As shown in Figure 35, a conductor 23 can be on the surface of the substrate 27 and extend under the flange 254 to contact the pad 215 which can couple the signal carried by the conductor 23 to the lead 216 of the packaged integrated circuit device 250 in some embodiments according to the invention. In some embodiments according to the invention, the conductor 23 can be any of the flexible electrical conductors described herein, such as a conductive thread in a woven fabric, a conductive thread in a knitted fabric, or a deposited flexible conductor layer. Other types of flexible electrical conductor may also be used. In some embodiments according to the invention, flange may be coupled to the substrate 27 by any of the structures shown, for example, in Figures 25A-25F.

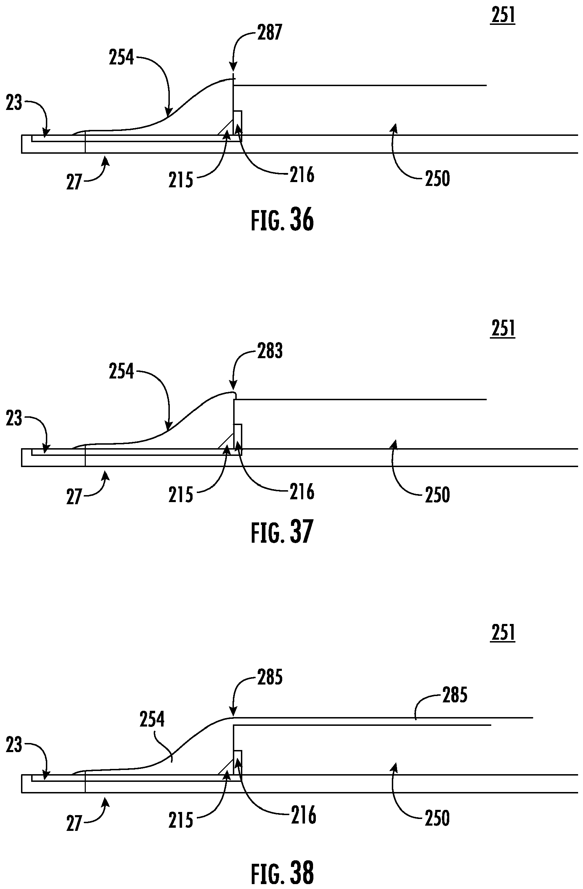

Figure 36 is a cross-sectional schematic illustrating the housing structure 251 mounted on a substrate 27 including the packaged integrated circuit device 250 secured in the recess in a right side up orientation where the leads 216 of the packaged integrated circuit device 250 are positioned remote from the hinge portion 257 of the flange 254 when inserted into the recess. In some embodiments according to the invention, the housing structure 251 is open at the top to expose the lower surface of the packaged integrated circuit device 250. In some embodiments according to the invention, the housing structure is open to expose the top portion of the packaged integrated circuit device 250. In some embodiments, the housing structure 251 is open to expose a PCB, transmitter, receiver, or sensor. In some embodiments, the housing structure 251 contains an optical lens or filter.

As shown in Figure 36, a conductor 23 can be on the surface of the substrate 27 and extend under the flange 254 to contact the pad 215 which can couple the signal carried by the conductor 23 to the lead 216 of the packaged integrated circuit device 250 in some embodiments according to the invention. In some embodiments according to the invention, the conductor 23 can be any of the flexible electrical conductors described herein, such as a conductive thread in a woven fabric, a conductive thread in a knitted fabric, or a deposited flexible conductor layer. Other types of flexible electrical conductor may also be used. In some embodiments according to the invention, flange may be coupled to the substrate 27 by any of the structures shown, for example, in Figures 25A-25F.

Figure 37 is a cross-sectional schematic illustrating the housing structure 251 mounted on a substrate 27 including the packaged integrated circuit device 250 secured in the recess in a right side up orientation where the leads 216 of the packaged integrated circuit device 250 are positioned remote from the hinge portion 257 of the flange 254 when inserted into the recess. In some embodiments according to the invention, the housing structure 251 includes a lip 283 that protrudes from an upper portion of the side wall 210 to extend over the upper surface of the packaged integrated circuit device 250 in some embodiments according to the invention.

As shown in Figure 37, a conductor 23 can be on the surface of the substrate 27 and extend under the flange 254 to contact the pad 215 which can couple the signal carried by the conductor 23 to the lead 216 of the packaged integrated circuit device 250 in some embodiments according to the invention. In some embodiments according to the invention, the conductor 23 can be any of the flexible electrical conductors described herein, such as a conductive thread in a woven fabric, a conductive thread in a knitted fabric, or a deposited flexible conductor layer. Other types of flexible electrical conductor may also be used. In some embodiments according to the invention, flange may be coupled to the substrate 27 by any of the structures shown, for example, in Figures 25A-25F.

Figure 38 is a cross-sectional schematic illustrating the housing structure 251 mounted on a substrate 27 including the packaged integrated circuit device 250 secured in the recess in a right side up orientation where the leads 216 of the packaged integrated circuit device 250 are positioned remote from the hinge portion 257 of the flange 254 when inserted into the recess. In some embodiments according to the invention, the housing structure 251 includes a top 285 that extends across the interior region to cover the upper surface of the packaged integrated circuit device 250 in some embodiments according to the invention.

As shown in Figure 38, a conductor 23 can be on the surface of the substrate 27 and extend under the flange 254 to contact the pad 215 which can couple the signal carried by the conductor 23 to the lead 216 of the packaged integrated circuit device 250 in some embodiments according to the invention. In some embodiments according to the invention, the conductor 23 can be any of the flexible electrical conductors described herein, such as a conductive thread in a woven fabric, a conductive thread in a knitted fabric, or a deposited flexible conductor layer. Other types of flexible electrical conductor may also be used. In some embodiments according to the invention, flange may be coupled to the substrate 27 by any of the structures shown, for example, in Figures 25A-25F.

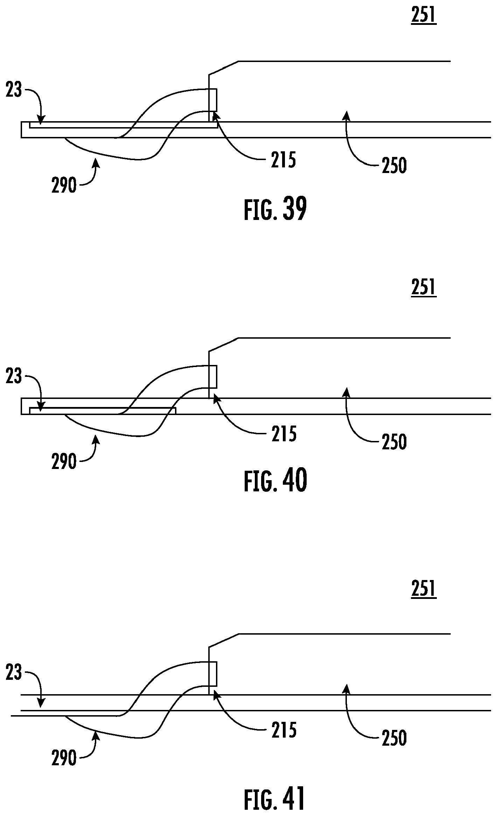

Figure 39 is a cross-sectional schematic illustrating the housing structure 251 mounted on a substrate where the housing structure 251 includes a prong lead 290 coupled to the housing structure 251, where the prong lead 290 extends from the side wall 210 of the housing structure 251 and curves downward to pierce the substrate to extend to a lower surface of the substrate that is opposite the surface where the housing structure 251 is mounted to secure the housing structure 251 to the fabric in some embodiments according to the invention.

Figure 40 is a cross-sectional schematic illustrating the housing structure 251 mounted on a substrate where the housing structure 251 includes a prong lead 290 coupled to the pad 215, where the prong lead 290 extends from the pad 215 and curves downward to pierce the substrate to extend to a lower surface of the substrate to electrically couple to a deposited flexible conductive layer within the fabric and to secure the housing structure 251 to the substrate in some embodiments according to the invention.

Figure 41 is a cross-sectional schematic illustrating the housing structure 251 mounted on a substrate where the housing structure 251 includes a prong lead 290 coupled to the pad 215, where the prong lead 290 extends from the pad 215 and curves downward to pierce the substrate to extend to a lower surface of the substrate to electrically couple to a deposited flexible conductive layer on the lower surface of the fabric and to secure the housing structure 251 to the substrate in some embodiments according to the invention.

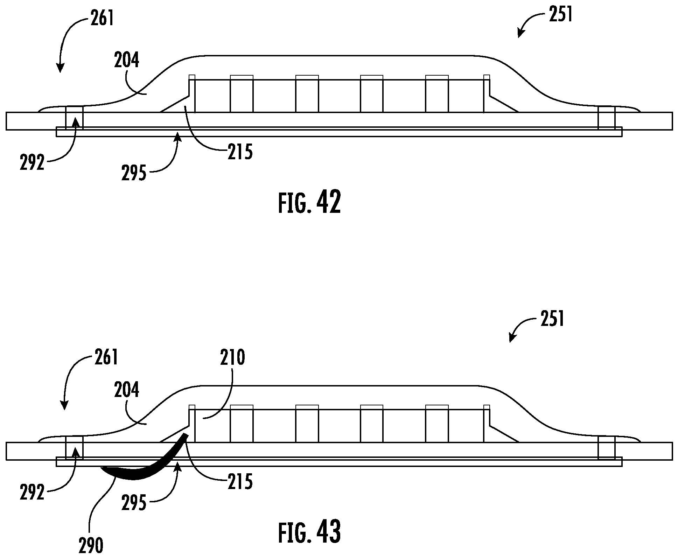

Figure 42 is a cross-sectional schematic illustrating the housing structure 251 mounted on a substrate where the housing structure 251 further includes rivets 292 that extend through the tail portion 261 of the flange 254 to secure the housing structure 251 to the substrate in some embodiments according to the invention. As further shown in Figure 42, a rigid backplate 295 extends beneath the substrate opposite the housing structure 251 to couple to the rivets 292 in some embodiments according to the invention.

Figure 43 is a cross-sectional schematic illustrating the housing structure 251 mounted on a fabric where the housing structure 251 includes a prong lead 290 that is coupled to a pad 215 of the housing structure 251 as shown in Figures 39-41 and where the housing structure also includes rivets 292 that extend through the tail portion 261 of the flange 204 in some embodiments according to the invention. In some embodiments according to the invention, where the prong lead 290 extends from the side wall 210 of the housing structure 251 and curves downward to pierce the substrate to extend to a lower surface of the substrate that is opposite the surface where the housing structure 251 is mounted to secure the housing structure 251 to the fabric. As further shown in Figure 43, the housing structure 251 further includes rivets 292 that extend through the tail portion 261 of the flange 254 to secure the housing structure 251 to the substrate in some embodiments according to the invention. A rigid backplate 295 extends beneath the substrate opposite the housing structure 251 to couple to the rivets 292 in some embodiments according to the invention.

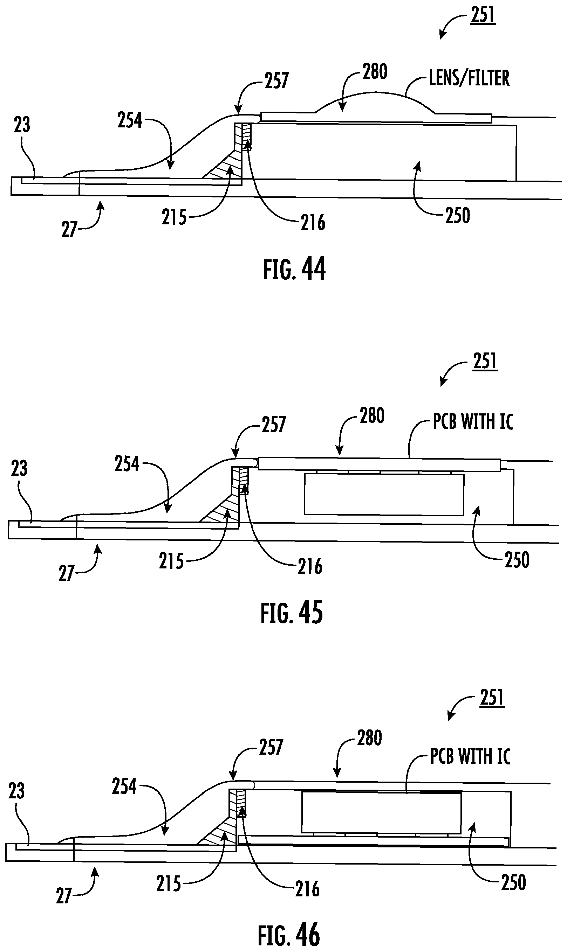

Figure 44 is a cross-sectional schematic illustrating the housing structure 251 mounted on a substrate 27 including a packaged integrated circuit device 250 secured in the recess in an upside-down orientation as shown in Figure 35 with a lens and/or filter coupled to a lower surface of the packaged integrated circuit device 250 in some embodiments according to the invention.

Figure 45 is a cross-sectional schematic illustrating the housing structure 251 mounted on a substrate 27 including a packaged integrated circuit device 250 secured to a PCB extending across an opening in the upper surface of the housing structure 251 in some embodiments according to the invention. Still further, the packaged integrated circuit device 250 secured to the PCB is in the recess in an upside-down orientation in some embodiments according to the invention.

Figure 46 is a cross-sectional schematic illustrating the housing structure 251 mounted on a substrate 27 including a packaged integrated circuit device 250 secured to a PCB extending across a lower surface of the recess in the housing structure 251 in some embodiments according to the invention. Still further, the packaged integrated circuit device 250 secured to the PCB is in the recess in a right side up orientation in some embodiments according to the invention.

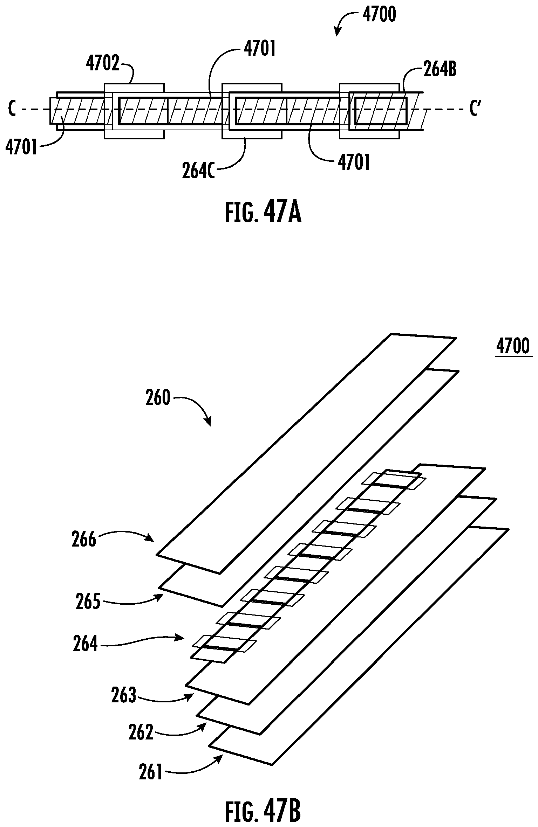

Figure 47A is a plan view schematic illustrating deposited flexible dielectric layers 4702 and deposited flexible conductive layers 4701 forming a plurality of capacitors 4700 in some embodiments according to the invention. Figure 47B is a perspective schematic illustrating the plurality of capacitors 4700 on a substrate 261 having a deposited flexible conductive shield layer 262 and deposited flexible dielectric layer 263 thereon.

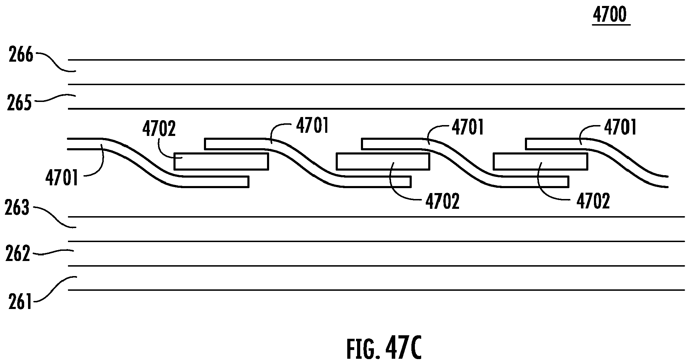

Further, a deposited flexible dielectric layer 265 and a deposited flexible conductive shield layer 266 are on the plurality of capacitors 4700 in some embodiments according to the invention. Figure 47C is a cross-sectional schematic illustrating the deposited flexible dielectric layers 4702 and the deposited flexible conductive layers 4701 above and beneath the deposited flexible dielectric layers 4702 to provide the plurality of capacitors taken along line C-C' shown in Figure 47A in some embodiments according to the invention. As further shown in Figure 47C, in some embodiments according to the present invention, the deposited flexible conductive layers 4701 extend over a first one of the deposited flexible dielectric layers 4702 and arcs downward to extend below an adjacent one of the deposited flexible dielectric layers 4702 so that the plurality of capacitors 4700 can be coupled in series with one another. In some embodiments, the deposited flexible dielectric layers 4702 can refer to one or more electrolytes.

As used herein any reference to "one embodiment" or "an embodiment" means that a particular element, feature, structure, or characteristic described in connection with the embodiment is included in at least one embodiment. The appearances of the phrase "in one embodiment" in various places in the specification are not necessarily all referring to the same embodiment.

Some embodiments may be described using the expression "coupled" and "connected" along with their derivatives. For example, some embodiments may be described using the term "coupled" to indicate that two or more elements are in direct physical or electrical contact. The term "coupled," however, may also mean that two or more elements are not in direct contact with each other, but yet still co-operate or interact with each other. The embodiments are not limited in this context.

As used herein, the terms "comprises," "comprising," "includes," "including," "has," "having" or any other variation thereof, are intended to cover a non-exclusive inclusion. For example, a process, method, article, or apparatus that comprises a list of elements is not necessarily limited to only those elements but may include other elements not expressly listed or inherent to such process, method, article, or apparatus. Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of the "a" or "an" are employed to describe elements and components of the embodiments herein. This is done merely for convenience and to give a general sense of various embodiments. This description should be read to include one or at least one and the singular also includes the plural unless it is obvious that it is meant otherwise.

It will be appreciated that elements in the figures are illustrated for simplicity and clarity and have not necessarily been drawn to scale. For example, the dimensions and/or relative positioning of some of the elements in the figures may be exaggerated relative to other elements to help to improve understanding of various embodiments of the present inventive concept. Also, common but well-understood elements that are useful or necessary in a commercially feasible embodiment are often not depicted in order to facilitate a less obstructed view of these various embodiments. The same reference numbers may be used to describe like or similar parts. Further, while several examples have been disclosed herein, any features from any examples may be combined with or replaced by other features from other examples. Moreover, while several examples have been disclosed herein, changes may be made to the disclosed examples within departing from the scope of the claims.

Those skilled in the art will recognize that a wide variety of modifications, alterations, and combinations can be made with respect to the above described embodiments without departing from the scope of the inventive concept, and that such modifications, alterations, and combinations are to be viewed as being within the ambit of the inventive concept.

The terminology used herein is for the purpose of describing embodiments only and is not intended to be limiting to other embodiments. As used herein, the singular forms "a," "an" and "the" are intended to include the plural forms as well, unless the context clearly indicates otherwise. It will be further understood that the terms "comprises," "comprising," "includes" and/or "including", "have" and/or "having" when used herein, specify the presence of stated features, integers, steps, operations, elements, and/or components, but do not preclude the presence or addition of one or more other features, integers, steps, operations, elements, components, and/or groups thereof. Elements described as being "to" perform functions, acts and/or operations may be configured to or other structured to do so.

Unless otherwise defined, all terms (including technical and scientific terms) used herein have the same meaning as commonly understood by one of ordinary skill in the art to which various embodiments described herein belong. It will be further understood that terms used herein should be interpreted as having a meaning that is consistent with their meaning in the context of this specification and the relevant art and will not be interpreted in an idealized or overly formal sense unless expressly so defined herein.

Any terms generally associated with circles, such as "radius" or "radial" or "diameter" or "circumference" or "circumferential" or any derivatives or similar types of terms are intended to be used to designate any corresponding structure in any type of geometry, not just circular structures. For example, "radial" as applied to another geometric structure should be understood to refer to a direction or distance between a location corresponding to a general geometric center of such structure to a perimeter of such structure; "diameter" as applied to another geometric structure should be understood to refer to a cross sectional width of such structure; and "circumference" as applied to another geometric structure should be understood to refer to a perimeter region. Nothing in this specification or drawings should be interpreted to limit these terms to only circles or circular structures.

Terms such as "substantially," "about," "approximately" or the like as used in referring to a relationship between two objects is intended to reflect not only an exact relationship but also variances in that relationship that may be due to various factors such as the effects of environmental conditions, common error tolerances, manufacturing variances, or the like. It should further be understood that although some values or other relationships may be expressed herein without a modifier, these values or other relationships may also be exact or may include a degree of variation due to various factors such as the effects of environmental conditions, common error tolerances, manufacturing variances, or the like.

In some embodiments, the term "about" generally refers to a range of numeric values that one of skill in the art would consider equivalent to the recited numeric value or having the same function or result. For example, "about" may refer to a range that is within ± 1%, ± 2%, ± 5%, ± 7%, ± 10%, ± 15%, or even ± 20% of the indicated value, depending upon the numeric values that one of skill in the art would consider equivalent to the recited numeric value or having the same function or result. Furthermore, in some embodiments, a numeric value modified by the term "about" may also include a numeric value that is "exactly" the recited numeric value. In addition, any numeric value presented without modification will be appreciated to include numeric values "about" the recited numeric value, as well as include "exactly" the recited numeric value. Similarly, the term "substantially" means largely, but not wholly, the same form, manner or degree and the particular element will have a range of configurations as a person of ordinary skill in the art would consider as having the same function or result. When a particular element is expressed as an approximation by use of the term "substantially," it will be understood that the particular element forms another embodiment.

Conditional language, such as, among others, "can," "could," "might," or "may," unless specifically stated otherwise, or otherwise understood within the context as used, is generally intended to convey that certain embodiments include, while other embodiments do not include, certain features, elements, and/or steps. Thus, such conditional language is not generally intended to imply that features, elements and/or steps are in any way required for one or more embodiments or that one or more embodiments necessarily include logic for deciding, with or without user input or prompting, whether these features, elements and/or steps are included or are to be performed in any particular embodiment.

Unless the context clearly requires otherwise, throughout the description and the claims, the words "include," "can include," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, or a combination thereof. Additionally, the words "herein," "above," "below," and words of similar import, when used in this application, refer to this application as a whole and not to any particular portions of this application. Where the context permits, words in the above Detailed Description using the singular or plural number may also include the plural or singular number, respectively. The word "or" in reference to a list of two or more items, covers all of the following interpretations of the word: any one of the items in the list, all of the items in the list, and any combination of the items in the list. Likewise the term "and/or" in reference to a list of two or more items, covers all of the following interpretations of the word: any one of the items in the list, all of the items in the list, and any combination of the items in the list.

Disjunctive language such as the phrase "at least one of X, Y, or Z," unless specifically stated otherwise, is otherwise understood with the context as used in general to present that an item, term, etc., may be either X, Y, or Z, or any combination thereof (non-limiting examples: X, Y, and/or Z). Thus, such disjunctive language is not generally intended to, and should not, imply that certain embodiments require at least one of X, at least one of Y, or at least one of Z to each be present.

Unless otherwise explicitly stated, articles such as "a" or "an" should generally be interpreted to include one or more described items. Accordingly, phrases such as "a device configured to" are intended to include one or more recited devices. Such one or more recited devices can also be collectively configured to carry out the stated recitations. For example, "a processor configured to carry out recitations A, B and C" can include a first processor configured to carry out recitation A working in conjunction with a second processor configured to carry out recitations B and C.

While the Detailed Description has shown, described, and pointed out novel features as applied to various embodiments, it can be understood that various omissions, substitutions, and changes in the form and details of the devices or algorithms illustrated can be made without departing from the spirit of the disclosure. As can be recognized, certain embodiments described elsewhere herein can be embodied within a form that does not provide all of the features and benefits set forth herein, as some features can be used or practiced separately from others. The scope of certain embodiments disclosed herein is indicated by the appended claims rather than by the foregoing description. All changes which come within the meaning and range of equivalency of the claims are to be embraced within their scope.

It will be understood that when an element is referred to as being "connected" or "coupled" to another element, it can be directly connected or coupled to the other element or intervening elements may be present. In contrast, if an element is referred to as being "directly connected" or "directly coupled" to another element, there are no intervening elements present. It will be understood that, although the terms first, second, etc. may be used herein to describe various elements, these elements should not be limited by these terms. These terms are only used to distinguish one element from another. Thus, a first element could be termed a second element without departing from the teachings of the present invention.

These and other changes can be made to the invention in light of the Detailed Description. While the above description describes certain examples of the invention, and describes the best mode contemplated, no matter how detailed the above appears in text, the invention can be practiced in many ways. Details of the system may vary considerably in its specific implementation, while still being encompassed by the invention disclosed herein. As noted above, particular terminology used when describing certain features or aspects of the invention should not be taken to imply that the terminology is being redefined herein to be restricted to any specific characteristics, features, or aspects of the invention with which that terminology is associated. In general, the terms used in the following claims should not be construed to limit the invention to the specific examples disclosed in the specification, unless the above Detailed Description section explicitly defines such terms. Accordingly, the actual scope of the invention encompasses not only the disclosed examples, but also all equivalent ways of practicing or implementing the invention under the claims.

## Claims

1. A stacked structure comprising:
a first deposited flexible dielectric layer;
a flexible electrical conductor on the first deposited flexible dielectric layer and configured to conduct an electrical signal; and
a second deposited flexible dielectric layer on the flexible electrical conductor opposite the first deposited flexible dielectric layer.

2. The stacked structure of Claim 1 wherein the flexible electrical conductor comprises a deposited flexible electrically conductive layer; and
wherein each of the first deposited flexible dielectric layer, the deposited flexible electrically conductive layer, and the second deposited flexible dielectric layer has a respective thickness in a first direction to provide a thickness of the stacked structure.

3. The stacked structure of Claim 2 wherein the first and second deposited flexible dielectric layers comprises polymer ink, elastomeric urethane, elastomeric silicone, plasticized acrylic, and/or solvent-disperse polymer and wherein the deposited flexible electrically conductive layer comprises conductive ink, silver nanoparticle, and/or copper nanoparticle ink.

4. The stacked structure of any one of Claims 1 to 3, wherein each of the first deposited flexible dielectric layer, the deposited flexible electrically conductive layer, and the second deposited flexible dielectric layer has a respective width in a second direction, that is different that the first direction; and
wherein the first and second deposited flexible dielectric layers have a first width and the deposited flexible electrically conductive layer has a second width that is less than the first width.

5. The stacked structure of any one of Claims 2 to 4, further comprising:
a first deposited flexible conductive shield layer between a flexible substrate and the first deposited flexible dielectric layers; and
a second deposited flexible conductive shield layer on the deposited flexible electrically conductive layer in the first and second directions and partially surrounding the first and second deposited flexible dielectric layers;
or
the stacked structure wherein the first and second deposited flexible dielectric layers are combined to surround the deposited flexible electrically conductive layer in the first and second directions, and said stacked structure further comprising:
a deposited flexible conductive shield layer surrounding the first and second deposited flexible dielectric layers and the deposited flexible electrically conductive layer in the first and second directions;
or
the stacked structure further comprising:
a first deposited flexible conductive shield layer on the first deposited flexible dielectric layer; and
a second deposited flexible conductive shield layer on the second deposited flexible dielectric layer.

6. The stacked structure of any one of Claims 2 to 5 further comprising:
a third deposited flexible dielectric layer between the first and second deposited flexible dielectric layers directly adjacent to the deposited flexible electrically conductive layer, wherein the third deposited flexible dielectric layer has a third dielectric constant;
a fourth deposited flexible dielectric layer between the first and second deposited flexible dielectric layers directly adjacent to the deposited flexible electrically conductive layer opposite the third deposited flexible dielectric layer, wherein the fourth deposited flexible dielectric layer has a fourth dielectric constant that is difference than the third dielectric constant
or
the stacked structure wherein the first deposited flexible dielectric layer has a first dielectric constant and the second deposited flexible dielectric layer has a second dielectric constant, the stacked structure further comprising:
a third deposited flexible dielectric layer on the second deposited flexible dielectric layer, wherein the third deposited flexible dielectric layer has a third dielectric constant;
a fourth deposited flexible dielectric layer on the first deposited flexible dielectric layer opposite the third deposited flexible dielectric layer, wherein the fourth deposited flexible dielectric layer has a fourth dielectric constant that is different than the first and third dielectric constants.

7. The stacked structure of any one of Claims 2 to 6 wherein the deposited flexible electrically conductive layer comprises a first deposited flexible electrically conductive layer, the stacked structure further comprising:
a second deposited flexible electrically conductive layer between the first and second deposited flexible dielectric layers directly adjacent to the first deposited flexible electrically conductive layer; and
a third deposited flexible electrically conductive layer between the first and second deposited flexible dielectric layers directly adjacent to the first deposited flexible electrically conductive layer opposite the second deposited flexible electrically conductive layer;
optionally, the stacked structure further comprising:
a fourth deposited flexible electrically conductive layer between the first and second deposited flexible dielectric layers directly adjacent to the second deposited flexible electrically conductive layer opposite the first deposited flexible electrically conductive layer, wherein the first and fourth deposited flexible electrically conductive layers both comprise electrical ground layers and wherein the second and third deposited flexible electrically conductive layers both comprise electrical signal layers.

8. The stacked structure of any one of Claims 2 to 7, wherein each of the deposited flexible electrically conductive layer, the first deposited flexible dielectric layer, and the second deposited flexible dielectric layer exhibits a respective electrically functional bending radius in a range between about 2 mm and about 0.5 mm; and/or
wherein the deposited flexible electrically conductive layer comprises a crease-able electrically conductive layer, the first deposited flexible dielectric layer comprises a first crease-able dielectric layer, and the second deposited flexible dielectric layer comprises a second crease-able dielectric layer; and wherein each of the crease-able electrically conductive layer, the first crease-able dielectric layer, and the second crease-able dielectric layer exhibits a respective functional natural bending angle in a range between about 1 degrees and about 180 degrees.

9. The stacked structure of any one of Claims 2 to 8, wherein each of the first deposited flexible dielectric layer, the deposited flexible electrically conductive layer, and the second deposited flexible dielectric layer has a respective length in a third direction, that is different that the first and second directions; and
wherein the first deposited flexible dielectric layer has a first thickness that is greater than a second thickness of the second deposited flexible dielectric layer wherein a difference between the first thickness and the second thickness is configured to bend the stacked structure in the third direction by a specified amount along a length of the stacked structure.

10. The stacked structure of any one of Claims 2 to 9, wherein the deposited flexible conductive layer comprises a first deposited flexible conductive layer, the stacked structure further comprising:
a second deposited flexible conductive layer between the first deposited flexible conductive layer and the second deposited flexible dielectric layer to provide an upper capacitor plate;
a third deposited flexible conductive layer between the first deposited flexible conductive layer and the first deposited flexible dielectric layer to provide a lower capacitor plate; and
a third deposited flexible dielectric layer between the upper capacitor plate and the lower capacitor plate.

11. The stacked structure of any one of Claims 1 to 10 wherein the flexible electrical conductor comprises a plurality of deposited flexible electrically conductive layers spaced apart from one another between the first and second deposited flexible dielectric layers; and
wherein each of the plurality of deposited flexible electrically conductive layers is configured to conduct separate electrical signals.

12. The stacked structure of any one of Claims 2 to 11, wherein each of the first deposited flexible dielectric layer and the second deposited flexible dielectric layer has a respective length in a third direction, that is different that the first and second directions, and wherein the flexible electrical conductor comprises a conductive thread integrated into a fabric in the third direction, the fabric having a first surface and a second surface that is opposite the first surface;
wherein the first deposited flexible dielectric layer is attached to the first surface of the fabric; and
wherein the second deposited flexible dielectric layer is attached to the second surface of the fabric;
optionally, wherein the conductive thread is integrated into the fabric to alternatingly cross over opposite sides of directly adjacent ones of a plurality of first dielectric threads extending in the second direction.

13. The stacked structure of Claim 12 wherein the conductive thread comprises a first conductive thread, the stacked structure further comprising:
a plurality of second dielectric threads spaced apart in the first direction; and
a second conductive thread spaced apart from the first conductive thread in the second direction and integrated into the fabric in the first direction to alternatingly cross over opposite sides of directly adjacent ones of the plurality of second dielectric threads.

14. The stacked structure of any one of Claims 2 to 13, wherein the deposited flexible dielectric layer includes a first surface and a second surface that is opposite the first surface;
wherein the deposited flexible electrically conductive layer comprises a first deposited flexible electrically conductive layer defining a first serpentine pattern on the deposited flexible dielectric layer including a plurality of first segments on the first surface of the deposited flexible dielectric layer and including a plurality of second segments on the second surface of the deposited flexible dielectric layer, the stacked structure further comprising:
a second deposited flexible electrically conductive layer defining a second serpentine pattern on the deposited flexible dielectric layer interlaced with the first serpentine pattern, the second deposited flexible electrically conductive layer including a plurality of first segments on the first surface of the deposited flexible dielectric layer and including a plurality of second segments on the second surface of the deposited flexible dielectric layer;
a plurality of first vias passing through the deposited flexible dielectric layer to connect the first and second segments of first serpentine pattern together; and
a plurality of second vias passing through the deposited flexible dielectric layer to connect the first and second segments of second serpentine pattern together
optionally, the stacked structure further comprising:
a pattern including a dielectric material and a piezoelectric material, the pattern located on the deposited flexible dielectric layer opposite where segments of the first and second serpentine patterns cross one another.

15. The stacked structure of any one of Claims 1 to 14, further comprising:
a garment including portions tailored for respective body parts;
a plurality electrical signal interconnects extending among the portions tailored for the respective body parts on the garment, the plurality of the electrical signal interconnects configured to conduct electrical signals among devices that are coupled to the garment;
wherein the first deposited flexible dielectric layer comprises a first crease-able dielectric layer coupled to the garment;
wherein the flexible electrical conductor comprises a crease-able electrically conductive layer on the first crease-able dielectric layer and configured to electrically conduct the electrical signals;
wherein the second deposited flexible dielectric layer comprises a second crease-able dielectric layer on the crease-able electrically conductive layer opposite the first crease-able dielectric layer; and
a plurality of electrical devices coupled to the garment and coupled to respective ones of the plurality electrical signal interconnects.
